(19) Europäisches Patentamt
European Patent Office
Office européen des brevets

(11) **EP 3 063 558 B1**

(12) **FASCICULE DE BREVET EUROPEEN**

(45) Date de publication et mention
de la délivrance du brevet:
**09.09.2020  Bulletin 2020/37**

(21) Numéro de dépôt: **14793831.0**

(22) Date de dépôt: **29.10.2014**

(51) Int Cl.:
*G01T 1/20* *(2006.01)*    *G01T 1/24* *(2006.01)*

(86) Numéro de dépôt international:
**PCT/EP2014/073229**

(87) Numéro de publication internationale:
**WO 2015/063156 (07.05.2015 Gazette 2015/18)**

(54) **CIRCUIT ELECTRONIQUE D'INJECTION DE CHARGES POUR DETECTEUR DE RAYONNEMENT**

ELEKTRONISCHE LADUNGSINJEKTIONSSCHALTUNG FÜR EINEN STRAHLUNGSDETEKTOR

ELECTRONIC CHARGE INJECTION CIRCUIT FOR RADIATION DETECTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2013  FR 1360551**

(43) Date de publication de la demande:
**07.09.2016  Bulletin 2016/36**

(73) Titulaires:
• **Commissariat à l'Énergie Atomique et aux Énergies Alternatives**
**75015 Paris (FR)**
• **Trixell**
**38430 Moirans (FR)**

(72) Inventeurs:
• **HABIB, Amr**
**F-13002 Marseille (FR)**
• **ARQUES, Marc**
**F-38100 Grenoble (FR)**

(74) Mandataire: **Collet, Alain et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A- 4 728 828      US-A- 5 652 430
US-A1- 2007 285 300   US-A1- 2010 194 951
US-B1- 6 670 598**

**Description**

L'invention concerne un circuit électronique pour un détecteur de rayonnement apte à quantifier un rayonnement de photons reçus au moyen d'un circuit d'injection de contre-charges. Elle concerne en particulier les détecteurs de rayonnement matriciels destinés à l'imagerie radiologique par rayons X ou gamma, comprenant une matrice de pixels de technologie CMOS associée à une structure de conversion des rayons X ou gamma en charges électriques.

Un détecteur de rayonnement matriciel comprend une matrice de pixels et un circuit électronique formant des moyens de lecture. Chaque pixel comprend un élément photosensible générant des charges électriques proportionnellement à la quantité reçue de photons. Ces charges électriques, également appelées photocharges, sont traitées par les moyens de lecture afin de fournir une information représentative de la quantité reçue de photons par chaque élément photosensible. L'utilisation de la technologie CMOS a permis d'intégrer les moyens de lecture au niveau de chaque pixel. Ainsi, les charges électriques peuvent être converties en signaux numériques à l'intérieur même des pixels pour faciliter le transfert du résultat de la détection vers l'extérieur de la matrice. Une solution courante pour réaliser les moyens de lecture est d'utiliser un circuit fonctionnant par intégration des charges électriques. Ce circuit d'intégration comprend une capacité d'intégration recevant les charges issues de l'élément photosensible, un comparateur à seuil, un compteur et un circuit d'injection de contre-charges. Pendant une phase d'exposition, l'arrivée de charges électriques sur la capacité d'intégration entraîne une diminution de la tension à ses bornes. Pendant une phase de lecture des charges électriques, le comparateur à seuil bascule un certain nombre de fois, tant que la tension aux bornes de la capacité d'intégration est inférieure à une tension seuil. Chaque basculement du comparateur incrémente le compteur d'une unité et commande au circuit d'injection l'injection d'un paquet de contre-charges dont la quantité Q0 est calibrée. Le compteur est ainsi incrémenté du nombre de paquets de charges nécessaire pour ramener une tension supérieure à la tension seuil aux bornes de la capacité d'intégration. Généralement, l'injection de contre-charges est réalisée au fur et à mesure que des photocharges sont collectées, un compteur déterminant le nombre de bascules du comparateur, afin d'estimer la quantité totale de charges injectée. La lecture correspond alors à la lecture du contenu des compteurs. Le nombre d'incrémentations du compteur fournit une valeur numérique représentative de la quantité de photons reçue par l'élément photosensible.

Le circuit d'injection de contre-charges est un élément critique du circuit d'intégration. En effet, la précision de la mesure repose sur le calibrage de la quantité Q0 de contre-charges. D'une part, la quantité Q0 de contre-charges doit être relativement faible puisqu'elle correspond au pas de la quantification des charges ; d'autre part, cette quantité doit être identique pour chaque paquet de contre-charges puisqu'elle quantifie les charges reçues par la capacité d'intégration.

Or, dans les circuits actuels d'injection de contre-charges, la quantité de charges injectées lors de chaque basculement du comparateur peut fluctuer. En effet, ces circuits comportent des transistors à effet de champ, dont les canaux sont affectés par un bruit aléatoire dit rts pour son acronyme anglo-saxon "Random Telegraph Signal". Le caractère aléatoire de ce bruit influe sur la quantité de contre-charges injectée : les injections sont affectées par ce bruit, différemment les unes des autres. Aussi, lorsqu'on souhaite estimer la charge totale injectée par un certain nombre d'injections, on ne sait pas exactement comment les injections ont été affectées.

Par exemple, un circuit d'injection de contre-charges comprend fréquemment deux transistors à effet de champ (FET) connectés en série et un condensateur connecté entre le point de liaison des transistors et une tension fixe, par exemple la masse. Un premier transistor permet de charger le condensateur à une première valeur de tension, dite tension de charge, commandée par la tension de grille de ce transistor. Le deuxième transistor permet de décharger le condensateur à une deuxième valeur de tension, dite tension de décharge, commandée par la tension de grille de ce transistor. La quantité Q0 de contre-charges injectées depuis le condensateur vers la capacité d'intégration du circuit d'intégration est fonction de la valeur de la capacité du condensateur et de la différence entre les tensions de charge et de décharge. Cependant, les tensions de charge et de décharge ne sont pas directement déductibles des tensions de grille des transistors. Les tensions de charge et de décharge correspondent aux potentiels internes des transistors, qui ne sont pas connus précisément en raison du bruit rts dû au piégeage de charges dans le canal de chaque transistor. Ce bruit rts est d'autant plus significatif que les composants ont des dimensions réduites afin de générer des quantités Q0 de contre-charges relativement faibles. En pratique, ce bruit rts modifie la valeur de la quantité Q0 de quelques pourcents. Cette modification se répercute directement sur l'évaluation de la quantité de photons reçue, et donc sur la qualité de l'image obtenue. Or, une telle erreur est généralement gênante, en particulier dans le domaine de l'imagerie médicale.

Des solutions pour remédier aux inconvénients précités existent. Elles consistent à déterminer précisément la quantité de contre-charges injectées pour évaluer la quantité de charges générées par un élément photosensible. Ainsi, la quantité de charges injectée à chaque basculement du comparateur est maîtrisée. La mesure de la quantité totale de la charge collectée par un détecteur est alors améliorée, ce qui accroît la précision de la mesure.

Cette technique fonctionne bien lorsque la quantité Q0 de contre-charges est importante. Néanmoins, lorsqu'on souhaite accéder à des charges Q0 plus petites (typiquement de l'ordre de 100 charges élémentaires injectées, c'est-à-dire des électrons ou des trous, ou moins), des inconvénients apparaissent. Par exemple, la charge injectée Q0 peut dépendre d'une différence de potentiel variable en raison de dispersions technologiques. La valeur de cette différence de potentiel doit être supérieure à sa variation pour que les dispersions de Q0 soient acceptables. Autrement dit, la variation de la différence de potentiel doit être négligeable par rapport à la différence de potentiel elle-même. De plus, pour obtenir de petites valeurs de Q0, on utilise des petits transistors qui sont plus sensibles au bruit rts. Ce bruit génère des variations de tensions de seuil, de durées variables. La correction de ces variations demande des dispositifs complexes.

Ce problème est abordé dans la demande de brevet FR2977413.

Le document US 2007/285300 décrit une autre variante circuit pour laquelle le signal est comparé à une seule valeur seuil.

L'invention vise à pallier tout ou partie des problèmes cités plus haut en proposant un circuit électronique pour détecteur de rayonnement permettant à la fois de maîtriser la quantité de charges injectée à chaque basculement du comparateur et de délivrer de petites quantités de contre-charges.

A cet effet, l'invention a pour objet un circuit électronique pour détecteur de rayonnement tel que revendiqué par la revendication indépendante 1 d'appareil.

L'invention a également pour objet un procédé mettant en œuvre le circuit selon l'une des revendications 1 à 9, le procédé comportant les étapes telle que revendiquées par la revendication indépendante 11 de procédé.

Selon un mode de réalisation, le potentiel d'équilibre correspond au potentiel au nœud d'intégration à l'issue d'une phase d'initialisation. Ce potentiel d'équilibre constitue alors le potentiel de déclenchement, au deçà ou au-delà duquel le circuit d'injection délivre une deuxième charge.

L'invention sera mieux comprise et d'autres avantages apparaîtront à la lecture de la description détaillée d'un mode de réalisation donné à titre d'exemple, description illustrée par le dessin joint dans lequel :

- la figure 1 représente un schéma électrique d'un pixel dans un détecteur de rayonnement selon l'état de la technique ;
- les figures 2A, 2B, 2C représentent des modes de réalisation d'un schéma électrique d'un pixel dans un détecteur de rayonnement selon l'invention ;
- la figure 3 représente un autre mode de réalisation de la première variante d'un schéma électrique d'un pixel dans un détecteur de rayonnement selon l'invention ;
- la figure 4 représente une autre variante d'un schéma électrique d'un pixel dans un détecteur de rayonnement selon l'invention ;
- la figure 5 représente une variante d'un schéma électrique d'un pixel dans un détecteur de rayonnement selon l'invention ;
- la figure 6 représente une variante d'un schéma électrique d'un pixel dans un détecteur de rayonnement selon l'invention ;
- la figure 7 représente une variante d'un schéma électrique d'un pixel dans un détecteur de rayonnement selon l'invention ;
- la figure 8 représente une variante d'un schéma électrique d'un pixel dans un détecteur de rayonnement selon l'invention ;
- la figure 9 illustre les étapes d'une phase d'initialisation mettant en œuvre le circuit électronique selon l'invention ;
- la figure 10 représente un détecteur de rayonnement comportant un circuit électronique selon l'invention ;
- la figure 11 représente une variante d'un schéma électrique d'un pixel dans un détecteur de rayonnement selon l'invention ;
- la figure 12 représente une variante d'un schéma électrique d'un pixel dans un détecteur de rayonnement selon l'invention ;
- la figure 13 représente une variante d'un schéma électrique d'un pixel dans un détecteur de rayonnement selon l'invention.

Par souci de clarté, les mêmes éléments porteront les mêmes repères dans les différentes figures.

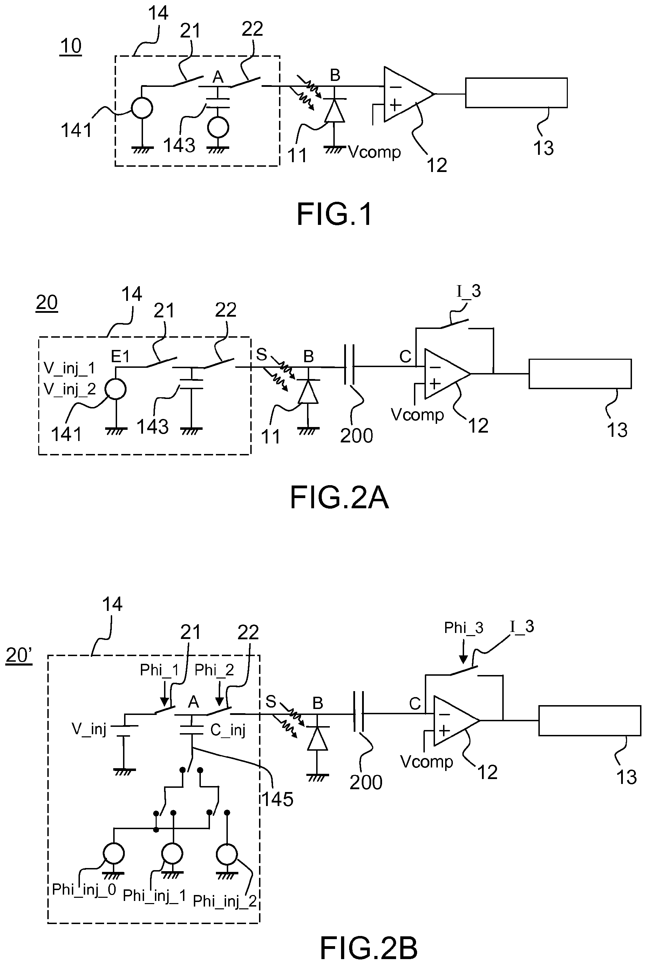

La figure 1 représente le schéma d'un circuit électronique d'un pixel 10 dans un détecteur de rayonnement matriciel selon l'état de la technique (comme par exemple décrit dans la demande de brevet FR2977413). Chaque pixel 10 forme un point photosensible du détecteur matriciel. Le circuit électronique comprend un élément sensible 11 au rayonnement, un comparateur 12 possédant un potentiel de basculement $V_{comp\_bascul}$ avec une première entrée recevant un potentiel de seuil $V_{comp}$ et une deuxième entrée apte à être connectée à un nœud d'intégration B relié à la cathode de l'élément sensible 11.

L'élément sensible 11 possède une capacité parasite. Des charges électriques générées par l'élément sensible 11 à la réception du rayonnement peuvent être stockées par la capacité parasite de l'élément sensible 11. Les charges collectées entraînent une variation du potentiel sur le nœud d'intégration B, dit potentiel d'intégration. L'élément sensible 11 peut être une photodiode ou un phototransistor ou, plus généralement, tout élément photosensible générant des charges électriques proportionnellement à la quantité de photons qu'il reçoit. Les photons considérés ont par exemple une longueur d'onde dans le domaine visible, dans le domaine de l'infrarouge ou dans le domaine des rayons X. Dans ce dernier cas, soit l'élément photosensible produit directement des charges électriques sous l'effet d'un rayonnement X, soit il est sensible au rayonnement visible, un scintillateur étant alors interposé entre la source de rayonnement X et l'élément photosensible.

L'élément sensible 11 possède une capacité parasite C_det utilisée comme capacité d'intégration pour stocker les charges électriques générées pendant une phase d'exposition. La capacité parasite C_det de l'élément sensible est généralement suffisante. Néanmoins, un condensateur pourrait être connecté en parallèle de l'élément sensible pour augmenter la capacité d'intégration, comme détaillé ci après. Une borne de l'élément sensible 11 est reliée à un potentiel fixe. Elle est par exemple connectée à la masse électrique. Le comparateur à seuil 12 reçoit sur une entrée positive le potentiel de seuil Vcomp. L'entrée négative est connectée au nœud d'intégration de l'élément sensible 11.

Le circuit électronique comprend un circuit d'injection 14 de charges, apte à injecter des charges au nœud d'intégration B. Le circuit d'injection 14 peut aussi être appelé injecteur. Le circuit d'injection 14 est apte à injecter des charges au nœud d'intégration B à chaque basculement du comparateur 12. Selon le fonctionnement du détecteur, ces charges sont soit positives (lorsque le détecteur collecte des électrons), soit négatives (lorsque le détecteur collecte des trous).

Lorsque le potentiel d'intégration $V_B$ s'écarte d'un seuil, dit potentiel de déclenchement, le circuit d'injection 14 est configuré pour injecter des charges au nœud d'intégration B. Lorsque le détecteur 11 collecte des électrons, le potentiel d'intégration $V_B$ devient inférieur au potentiel de déclenchement. Le comparateur 12 bascule, ce qui entraîne une injection de charges, dites « contre-charges », au nœud d'intégration B. Le terme contre-charges désigne le fait que les charges injectées sont destinées à ramener le potentiel d'intégration $V_B$ en dessus du potentiel de déclenchement.

De manière analogue, lorsque le détecteur 11 collecte des charges positives (aussi appelées trous), le potentiel d'intégration $V_B$ devient supérieur au potentiel de déclenchement. Le comparateur 12 bascule, ce qui entraîne une injection de charges destinées à ramener le potentiel d'intégration $V_B$ en dessous du potentiel de déclenchement.

Ainsi, d'une façon générale, le circuit d'injection de charges 14 est apte à injecter des charges vers le nœud d'intégration B en fonction d'une comparaison entre le potentiel d'intégration $V_B$ et le potentiel de déclenchement.

Le circuit d'injection 14 fonctionne en mode impulsionnel : il délivre une quantité déterminée Q0 de charges sous l'action d'une impulsion. On parle également de cycles d'injection. Tant que le potentiel d'intégration $V_B$ n'a pas franchi le potentiel de déclenchement, le circuit d'injection 14 injecte successivement ladite quantité de charges Q0.

Dans l'exemple représenté sur la figure 1, le potentiel de déclenchement est relié au potentiel $V_{comp}$ de l'entrée du comparateur 12, à l'offset du comparateur près. Lorsque le potentiel d'intégration $V_B$ est inférieur au potentiel de basculement du comparateur 12, appelée $V_{comp\_bascul}$, le comparateur 12 bascule, ce qui entraîne des injections successives de contre-charges, jusqu'à ce que le potentiel d'intégration $V_B$ franchisse $V_{comp\_bascul}$. Ainsi, dans cet exemple, le potentiel de déclenchement correspond à $V_{comp\_bascul}$.

Le circuit électronique comprend un compteur 13 connecté en sortie du comparateur 12 de manière à comptabiliser le nombre de basculements du comparateur, c'est-à-dire comptabiliser le nombre de cycles d'injection de charges. Des éléments de mise en forme du signal issu du comparateur 12 peuvent être interposés entre ce dernier et le compteur 13.

Le comparateur à seuil 12, le compteur 13 et le circuit d'injection 14 forment un circuit électronique permettant une lecture de l'élément sensible 11.

Le circuit d'injection de contre-charges 14 comprend deux interrupteurs 21 et 22 pilotés respectivement par Phi_1 et Phi_2, une source de tension 141 de tension d'injection V_inj, un condensateur 143 de capacité d'injection C_inj. L'interrupteur 21, l'interrupteur 22 et une borne du condensateur 143 sont reliés en un point A, appelé nœud du circuit d'injection de contre-charges. Le premier interrupteur 21 permet de connecter la source de tension 141 et le point A précédemment défini. Le premier interrupteur 21 permet de constituer une charge au niveau du nœud A du circuit d'injection de charge. On l'appellera interrupteur de précharge.

L'interrupteur 22 permet de connecter le point A à la cathode de l'élément sensible 11, de manière à pouvoir y injecter des contre-charges. Aussi, l'interrupteur 22 peut être appelé interrupteur de transfert. Précisons que la cathode de l'élément sensible 11 correspond également au point où s'accumulent des charges générées par les interactions du rayonnement dans le détecteur. Ce point peut être appelé nœud d'intégration B du pixel. Autrement dit, le nœud B est un point de connexion entre l'élément sensible 11 et son circuit électronique de lecture. Il peut recevoir, d'une part, des charges électriques de l'élément sensible 11 lorsqu'il est exposé et, d'autre part, des contre-charges électriques du circuit d'injection de contre-charges 14.

La collection de charges électriques et l'injection de contre-charges sur le nœud B entraînent une variation du potentiel au nœud d'intégration B. A titre d'exemple, on considère que, lors de la réception de photons, l'élément sensible 11 génère des charges négatives (des électrons) stockées sur sa cathode. Ces charges négatives entraînent une diminution du potentiel au nœud B. Lorsque le potentiel au nœud B devient inférieur au potentiel de basculement du comparateur $V_{comp\_bascul}$, le comparateur 12 bascule. Chaque basculement est comptabilisé par le compteur 13.

Le principe de fonctionnement du circuit d'injection de contre-charges 14 est le suivant. On choisit le potentiel d'injection V_inj supérieur au potentiel de seuil $V_{comp}$ de delta_V_inj. Autrement dit, le potentiel d'injection V_inj de 141 est égale à la somme du potentiel de seuil $V_{comp}$ et de delta_V_inj. On précharge le point A au potentiel V_inj par une impulsion Phi_1 de l'interrupteur 21. Lorsque le potentiel $V_B$ au nœud d'intégration B passe en-dessous du potentiel de basculement du comparateur, l'interrupteur 22 est rendu passant par une impulsion Phi_2. On injecte alors sur le nœud d'intégration B une charge Q0. La quantité Q0 de contre-charges injectées sur le nœud d'intégration B et donc sur l'élément sensible 11 vaut C_inj x delta_V_inj x C_det / (C_det + C_inj). On répète le cycle de précharge et d'injection autant de fois que nécessaire, c'est-à-dire jusqu'à ce que le potentiel au nœud B atteigne le potentiel de basculement du comparateur. Ces cycles sont comptés dans le compteur. Il est à noter que la capacité de l'élément sensible 11 peut être suffisamment faible pour que l'injection d'une seule contre-charge amène le potentiel du nœud B au potentiel de basculement, ce qui entraîne le basculement du comparateur 12.

Supposons maintenant que C_inj x C_det / (C_det + C_inj) soit égal à un femto Farad (fF), ce qui est déjà plus faible que ce qu'on maîtrise généralement en conception CMOS. Si on souhaite une valeur de Q0 égale à 100 charges élémentaires injectées, il faut alors que : delta_V_inj = 100 x q / 1fF = 16 mV.

Les comparateurs des différents pixels de l'imageur sont soumis à des variations des tensions de seuil, de l'ordre de 10 mV, et qui varient d'un pixel à l'autre notamment à cause des dispersions technologiques, de la température et du vieillissement de l'imageur. Il est donc très difficile, voire impossible, de maîtriser une charge Q0 faible.

Par ailleurs, il y a des capacités parasites dans le montage, en particulier avec les commandes Phi_1 et Phi_2 des interrupteurs 21 et 22. Si on suppose que Phi_1 et Phi_2 sont pulsées entre 0 et 1.2V et que les capacités parasites sont aussi de 1 femto Farad, alors les charges parasites injectées sont de 1.2 x 1 fF / q, soit 7500 charges élémentaires injectées.

Le schéma électrique d'un pixel dans un détecteur de rayonnement selon l'état de la technique n'est pas adapté à la fabrication de petites contre-charges Q0. L'invention présentée vise à proposer un schéma électrique fonctionnel avec des petites contre-charges Q0.

La figure 2A représente un premier mode de réalisation du circuit électronique d'un détecteur de rayonnement selon l'invention. Le schéma électrique du pixel 20 comprend les mêmes éléments que le schéma électrique du pixel 10 représenté sur la figure 1. Selon l'invention, le circuit d'injection 14 est apte à injecter une charge à une borne de l'élément sensible (11). Le circuit d'injection 14 s'étend entre au moins une borne d'entrée E1 et une borne de sortie S, la borne de sortie S étant apte à être connectée audit élément sensible 11. Le circuit d'injection 14 est apte à produire une charge sous l'effet d'une impulsion de déclenchement. Selon ce mode de réalisation, le circuit d'injection 14 est apte à injecter une première charge lorsqu'une borne d'entrée E1 est raccordée à un premier potentiel V_inj_1 d'entrée et une deuxième charge lorsqu'une borne d'entrée E1 est raccordée à un deuxième potentiel d'entrée V_inj_2. Le circuit électronique comporte un moyen de mémorisation d'une différence entre un potentiel de sortie Vs du circuit d'injection 14, dit potentiel d'équilibre $V_{equ}$, et un potentiel de référence et de telle sorte que la deuxième charge dépend du deuxième potentiel d'entrée et dudit potentiel d'équilibre $V_{equ}$. Dans cet exemple, le potentiel de référence correspond au potentiel de basculement du comparateur.

Le circuit d'injection 14 est relié au nœud d'intégration B et est apte à délivrer une charge Qtot. Le circuit électronique du pixel 20 comprend en outre des moyens pour placer le comparateur 12 à la tension de basculement quand le nœud d'intégration B atteint un potentiel d'équilibre, noté $V_{equ}$, pendant une phase d'initialisation, et un moyen de mémorisation connecté à une entrée du comparateur 12 aptes à stocker la tension de basculement du comparateur 12.

Dans la figure 2A, le moyen de mémorisation comprend un deuxième condensateur 200 relié à la deuxième entrée du comparateur 12, l'entrée inverseuse, et un interrupteur I_3 raccordé entre l'entrée inverseuse du comparateur 12, à laquelle est relié le deuxième condensateur 200, et la sortie du comparateur 12. Le condensateur 200 de capacité $C_L$ est raccordé entre le nœud d'intégration B et un point C correspondant à l'entrée inverseuse du comparateur 12. Le condensateur 200 doit disposer d'une capacité $C_L$ suffisamment forte devant les capacités parasites afin que les variations de tension au nœud d'intégration B soient, au premier ordre, transmises à la deuxième entrée du comparateur 12.

Dans cette première variante, le circuit d'injection 14 comporte une borne d'entrée E1, apte à être raccordée à un premier potentiel (V_inj_1) ou à un deuxième potentiel (V_inj_2). Il comporte également une borne de sortie S, qui correspond ici au nœud d'intégration B du détecteur 11.

Lorsque la borne d'entrée E1 est raccordée au premier potentiel (V_inj_1), le circuit d'injection 14 délivre une première charge Q1. Lorsque la borne d'entrée E1 est raccordée au deuxième potentiel (V_inj_2), le circuit d'injection 14 délivre une deuxième charge Q2.

Dans une première phase d'initialisation, la borne d'entrée E1 du circuit d'injection 14 est raccordée au premier potentiel V_inj_1. Les deux interrupteurs 21 et 22 sont passants. La tension aux bornes de l'élément sensible 11 est donc égale à V_inj_1. L'interrupteur I_3 est également passant. Le comparateur 12 est proche de son potentiel de basculement $V_{comp\_bascul}$. Le potentiel de basculement correspond au potentiel de seuil Vcomp, à l'offset près du comparateur 12. La capacité $C_L$ du condensateur 200 est donc chargée à une tension égale à la différence entre le premier potentiel d'injection (V_inj_1) et le potentiel de basculement du comparateur 12, soit (V_inj_1- $V_{comp\_bascul}$). On bloque alors l'interrupteur I_3. Le terme bloquer désigne le fait qu'on ouvre l'interrupteur. La charge sur le condensateur 200 est alors figée.

Ainsi, la tension aux bornes de la capacité de liaison $C_L$ est fixée à une valeur prenant en compte le premier potentiel (V_inj_1) ainsi que le potentiel de basculement du comparateur ($V_{comp\_bascul}$), ce dernier pouvant être assimilé à un potentiel de référence fixe. En effet, il dépend du potentiel de seuil (potentiel de l'entrée non inverseuse) et de l'offset du comparateur 12. Chaque fois que le potentiel du nœud d'intégration B atteint le premier potentiel d'injection V_inj_1, l'entrée inverseuse du comparateur 12 est au potentiel de basculement $V_{comp\_bascul}$.

Lorsque l'interrupteur I_3 est bloqué, la capacité constitue un moyen de mémorisation d'une différence entre le potentiel au nœud d'intégration, qui est aussi le potentiel de la borne de sortie S du circuit d'injection 14, et le potentiel de référence $V_{comp\_bascul}$. On rappelle que la borne de sortie S et le nœud d'intégration B étant confondus.

A l'issue de la phase d'initialisation, la différence de potentiel stockée aux bornes de la capacité correspond à la différence entre un potentiel à la sortie de l'injecteur, dit potentiel d'équilibre $V_{equ}$ (avec, dans cet exemple, $V_{equ}$ = V_inj_1) et le potentiel de référence $V_{comp\_bascul}$.

Dans une deuxième phase d'utilisation du détecteur, les interrupteurs 21 et 22 sont initialement bloqués. On règle alors le potentiel d'injection V_inj égal au deuxième potentiel V_inj_2, avec

$$V\_inj\_2 - V\_inj\_1 = delta\_V\_inj \ .$$

On active alors le premier interrupteur 21 par une impulsion, pour précharger le nœud A du circuit d'injection 14 au deuxième potentiel d'injection V_inj_2.

Lorsqu'une interaction se produit dans le détecteur 11, la charge collectée par le détecteur modifie le potentiel $V_B$ au nœud d'intégration B. Chaque fois que le potentiel au nœud d'intégration B atteint le potentiel d'injection V_inj_1, l'entrée C du comparateur 12 est à son potentiel de basculement. Un cycle d'injection de contre-charges est déclenché : lorsque le potentiel de l'entrée C du comparateur 12 est inférieur au potentiel de basculement $V_{comp\_bascul}$, l'interrupteur 22 est rendu passant par une impulsion de Phi_2. On injecte alors sur le nœud d'intégration B une deuxième charge Q2. La quantité Q2 de contre-charges injectées sur le nœud d'intégration B et donc sur l'élément sensible 11 vaut

$$Q2 = \frac{(C\_inj \times delta\_V\_inj \times C\_det)}{(C\_det + C\_inj)} \ .$$

Ainsi, la deuxième charge dépend du deuxième potentiel d'entrée V_inj_2 du circuit d'injection 14, et du potentiel de sortie V_inj_1 mémorisé alors que le circuit d'injection 14 délivre une première charge Q1.

L'ensemble formé par les deux interrupteurs 21 et 22 et le condensateur 143 de capacité d'injection C_inj peut être considéré comme une résistance à capacités commutées : la quantité de charge délivrée est proportionnelle à la différence de potentiel entre le potentiel d'entrée (V_inj_1 ou V_inj_2) et le potentiel de sortie.

On répète le cycle de précharge et d'injection autant de fois que nécessaire, c'est-à-dire jusqu'à ce que le potentiel au nœud B atteigne ou dépasse un potentiel d'équilibre $V_{equ}$, ce dernier étant égal à V_inj_1 dans ce mode de réalisation, l'effet des charges parasites ayant été négligé. Autrement dit, le circuit d'injection 14 injecte des charges en fonction de la valeur du potentiel au nœud d'intégration B, et les interrupteurs 21, 22 du circuit d'injection 14 sont activés une pluralité de fois, dépendant de la quantité de charge collectée par le détecteur lors de l'interaction. Ces cycles sont comptés dans le compteur 13, de façon à estimer la charge totale collectée.

L'introduction du condensateur 200 permet de s'affranchir des variations de tension de basculement du comparateur 12. Elle permet aussi de choisir le potentiel de fonctionnement $V_B$ de l'élément sensible 11 indépendamment du potentiel de basculement du comparateur 12, ce qui est particulièrement intéressant quand l'élément sensible 11 et le comparateur 12 n'ont pas les mêmes optima de potentiel de fonctionnement.

Par contre, la présence de capacités parasites dans le circuit électronique a pour conséquence une injection de charges Q2 beaucoup plus importantes qu'il n'est souhaité.

En l'absence d'injection volontaire, c'est-à-dire si le deuxième potentiel d'injection V_inj_2 est choisi égal au premier potentiel d'injection V_inj_1, les couplages parasites créent une injection parasite Qpar. Ainsi, à chaque cycle d'injection des interrupteurs 21 et 22, une quantité Qpar est injectée sur le noeud d'intégration B alors que delta_V_inj = 0. Par conséquent, le potentiel du nœud d'intégration B évolue positivement si Qpar est positive et négativement si Qpar est négative.

Selon un deuxième mode de réalisation, on cherche à s'affranchir de l'effet de charges parasites, afin de maîtriser la quantité de charges injectées, à chaque cycle, lors du fonctionnement du détecteur. Selon ce mode de réalisation, au cours de la phase d'initialisation, on effectue successivement plusieurs injections de premières charges Q1.

A chaque injection, une quantité de charges parasites Qpar est injectée au nœud d'intégration B, cette quantité étant positive ou négative. Lors de l'injection suivante, si le potentiel du nœud d'intégration B est devenu positif (respectivement négatif) par rapport au premier potentiel V_inj_1, c'est-à-dire par rapport au potentiel de précharge du point A, alors, lorsque l'interrupteur 22 devient passant, une charge positive $Q_{echap}$ (respectivement négative) s'échappe de B pour aller vers A afin de s'opposer à la croissance (respectivement décroissance) du potentiel du nœud d'intégration B. Les charges s'échappant du nœud d'intégration B pour aller vers le point A sont d'autant plus importantes que la tension du nœud d'intégration B augmente (respectivement décroît).

En présence de capacités parasites de couplage, il existe nécessairement un potentiel d'équilibre à la sortie de l'injecteur S, noté $V_{equ}$, pour lequel l'apport de charges Qpar par le parasite est égal à l'échappement des charges $Q_{echap}$ lorsque l'interrupteur 22 est passant. Lorsque ce potentiel d'équilibre est atteint, la charge injectée est nulle et ne fluctue pas du fait des charges parasites. Par charge injectée nulle, on entend une charge inférieure à un seuil prédéterminé, au dessous duquel l'injection de charge est considérée comme négligeable.

La première charge Q1 injectée peut être exprimée par la relation :

$$Q1 = (V\_inj\_1 - Vs) \times (C\_inj \times C\_det)/(C\_det + C\_inj) + Qpar,$$

Vs correspondant au potentiel de sortie de l'injecteur ($V_S = V_B$).
Lorsque Vs atteint le potentiel d'équilibre $V_{equ}$, Q1 = 0, donc

$$Qpar = - (V\_inj\_1 - Vequ) \times (C\_inj \times C\_det)/(C\_det + C\_inj).$$

Pour tenir compte de l'établissement d'un tel potentiel d'équilibre, le principe de fonctionnement du circuit comporte une phase d'initialisation comportant les étapes suivantes :

- Connexion d'une borne d'entrée du circuit d'injection à un premier potentiel,
- Injection d'une première charge sur la borne de sortie du circuit d'injection,
- Mémorisation d'une différence entre un potentiel de sortie (Vs) du circuit d'injection (14), dit potentiel d'équilibre ($V_{equ}$), et un potentiel de référence $V_{ref}$, cette mémorisation étant effectuée de préférence lorsque ladite première charge, délivrée par le circuit d'injection, est inférieure à un seuil prédéterminé,

- Eventuellement mise du nœud d'intégration à un potentiel de déclenchement,
- Connexion d'une borne d'entrée du circuit d'injection à un deuxième potentiel, de telle sorte que l'injecteur délivre une deuxième charge en fonction de la différence entre le potentiel du nœud d'intégration et le potentiel de déclenchement.

Selon ce mode de réalisation, le potentiel de référence $V_{ref}$ est un potentiel fixe, correspondant au potentiel de basculement $V_{comp\_bascul}$ du comparateur

La phase d'initialisation ainsi définie a pour but de prendre en compte tous les parasites et de les annuler. On donne au potentiel d'injection V_inj la valeur V_inj_1. Autrement dit, la borne d'entrée E1 du circuit d'injection 14 est raccordée au premier potentiel V_inj_1, de façon à injecter une première charge Q1 au nœud d'intégration B. L'interrupteur I_3 est passant. L'entrée C du comparateur 12 est à son potentiel de basculement $V_{comp\_bascul}$, c'est-à-dire V_C est égale à $V_{comp\_bascul}$. On active successivement les interrupteurs 21 et 22 un nombre suffisant de fois pour que le potentiel du nœud d'intégration B, qui correspond également au potentiel de sortie du circuit d'injection 14, atteigne le potentiel d'équilibre $V_{equ}$ précédemment décrit.

En théorie, plus le nombre de cycles de fermeture et d'ouverture des deux interrupteurs 21 et 22 est élevé, plus le potentiel au nœud d'intégration B se rapproche asymptotiquement du potentiel d'équilibre Vequ. Typiquement, on pulse entre 10 et 100 fois, sur une durée d'environ 50 μs. Le potentiel d'équilibre $V_{equ}$ est atteint quand la charge injectée est considérée comme nulle, le potentiel du nœud d'intégration B étant alors égal à $V_{equ}$. A cet instant, ce potentiel d'équilibre $V_{equ}$ n'évolue plus entre deux injections de charges successives.

Le circuit électronique comprend un moyen pour mémoriser la différence de potentiel entre le potentiel d'équilibre $V_{equ}$ et un potentiel de référence $V_{ref}$, correspondant dans cet exemple au potentiel de basculement du comparateur 12, au bout d'un nombre prédéterminé d'impulsions de déclenchement. Dans la pratique, on mémorise le potentiel d'équilibre lorsqu'on estime qu'il est atteint à une erreur acceptable près. Lorsqu'il est atteint, le potentiel de sortie du circuit d'injection n'évolue plus de façon significative : la charge délivrée, à chaque injection de charge, est alors nulle à un seuil prédéterminé près. Le nombre prédéterminé d'impulsions de déclenchement est déterminé soit expérimentalement, soit par des simulations.

La phase d'initialisation s'achève par la mémorisation, aux bornes du condensateur 200 de capacité de liaison $C_L$, d'une différence entre un potentiel de sortie Vs du circuit d'injection 14, dit potentiel d'équilibre $V_{equ}$, et le potentiel de référence $V_{ref}$. Cette mémorisation est obtenue en ouvrant l'interrupteur $I\_3$, de telle sorte que la charge sur le condensateur 200 soit figée et égale à $V_{equ}$ - $V_{comp\_bascul}$. Cette charge prend en compte non seulement les variations de tension de basculement du comparateur 12, mais aussi la tension d'équilibre du nœud d'intégration B liée aux couplages parasites.

La suite du fonctionnement du circuit est identique au cas présenté précédemment : la borne d'entrée E1 du circuit d'injection de charges 14 est raccordée à un deuxième potentiel V_inj_2., de telle sorte qu'à chaque injection de charge, le circuit d'injection de charges 14 injecte une deuxième charge Q2,

$$Q2 = (V\_inj\_2 - Vequ) \times (C\_inj \times C\_det)/(C\_det + C\_inj) + Qpar,$$

où Qpar représente la charge parasite.
Or

$$Qpar = - (V\_inj\_1 - Vequ) \times (C\_inj \times C\_det)/(C\_det + C\_inj).$$

Donc

$$Q2 = (V\_inj\_2 - V\_inj\_1) \times (C\_inj \times C\_det)/(C\_det + C\_inj).$$

On remarque que la quantité de contre-charges injectée Q0 = Q2 est indépendante de Qpar.

Chaque fois que le potentiel au nœud d'intégration s'écarte du potentiel d'équilibre $V_{equ}$, et donc que le comparateur 12 est à son potentiel de basculement, un cycle d'injection de contre-charges est déclenché, les interrupteurs 21 et 22 étant actionnés. On injecte alors sur le nœud d'intégration B une charge Q2. On répète le cycle de précharge et d'injection autant de fois que nécessaire, c'est-à-dire jusqu'à ce que le potentiel au nœud B atteigne le potentiel d'équilibre $V_{equ}$. Ces cycles sont comptés dans le compteur. On remarque que selon ce mode de réalisation, le potentiel de déclenchement, qui correspond au potentiel en deçà duquel une injection de charges est commandée, correspond au potentiel d'équilibre $V_{equ}$.

La phase d'initialisation permet de supprimer l'effet des parasites de couplage d'une façon automatique. Elle permet de s'adapter aux variations que l'on peut rencontrer sur un pixel, à savoir les variations technologiques, thermiques, de pilotage, ainsi que les variations dues au vieillissement.

Ainsi, on maîtrise la contre-charge injectée à chaque basculement du comparateur, cette dernière pouvant être ajustée en réglant V_inj_1 et V_inj_2.

On peut renouveler la phase d'initialisation par exemple lorsque la température ambiante varie ou de façon périodique pour se prémunir du vieillissement.

Selon une variante de ce mode de réalisation, représentée sur le pixel 20' de la figure 2B, le circuit d'injection 14 comporte une borne d'entrée 145 apte à être commutée entre :

- un premier potentiel d'entrée, égal à Phi_inj_1 et un potentiel de base Phi_inj_0,
  ou
- un deuxième potentiel d'entrée, égal à Phi_inj_2 et un potentiel de base Phi_inj_0.

Par ailleurs, le circuit d'injection 14 est connecté à un potentiel d'alimentation fixe V_inj. L'injection d'une charge est obtenue en actionnant l'interrupteur 21, de façon à précharger la capacité d'injection C_inj, tandis que la borne d'entrée 145 est reliée au potentiel de base Phi_inj_0. Lorsque la capacité C_inj est préchargée, l'interrupteur 21 est bloqué puis l'interrupteur 22 est rendu passant ; la borne d'entrée 145 est alors reliée au premier potentiel Phi_inj_1, permettant l'injection d'une première charge Q1 à la sortie S du circuit d'injection 14, qui correspond au nœud d'intégration B.

$$Q1 = (V\_inj - Vs) \times (C\_inj \times C\_det)/(C\_det + C\_inj) + Qpar$$
$$+ (Phi\_inj\_1 - Phi\_inj\_0) \times (C\_inj \times C\_det)/(C\_det + C\_inj).$$

Durant la phase d'initialisation, de même que dans le précédent mode de réalisation, on effectue une pluralité d'injections de premières charges Q1, jusqu'à ce que le potentiel de sortie Vs atteigne un potentiel d'équilibre $V_{equ}$. A ce moment, la première charge injectée Q1, inférieure à un seuil prédéterminé, est considérée comme nulle. On bloque alors l'interrupteur 1_3, de façon à mémoriser, aux bornes de la capacité C2, une différence entre le potentiel d'équilibre $V_{equ}$ à la sortie de l'injecteur (c'est-à-dire au nœud d'intégration B) et un potentiel de référence, $V_{ref}$, ce dernier correspondant au potentiel de basculement $V_{comp\_bascul}$ du comparateur 12.

A l'issue de cette phase d'initialisation, la borne d'entrée 145 est commutée entre le potentiel de base Phi_inj_0 et le deuxième potentiel Phi_inj_2, de telle sorte que le circuit d'injection 14 est apte à générer une deuxième charge Q2, telle que

$$Q2 = (V\_inj - Vequ) \times (C\_inj \times C\_det)/(C\_det + C\_inj) + Qpar$$
$$+ (Phi\_inj\_2 - Phi\_inj\_0) \times (C\_inj \times C\_det)/(C\_det + C\_inj).$$

Comme précédemment observé, sachant que Q1 = 0 lorsque Vs = $V_{equi}$,

$$Q2 = (Phi\_inj\_2 - Phi\_inj\_1) \times (C\_inj \times C\_det)/(C\_det + C\_inj).$$

On remarque que la quantité de contre-charges injectée Q0 = Q2 est indépendante de Qpar.

De même que dans l'exemple précédent, le potentiel de déclenchement, qui correspond au potentiel en deçà duquel une injection de charges est commandée, correspond au potentiel d'équilibre Vequ.

Les interrupteurs 21, 22 et I_3 ne sont jamais parfaits. Ils possèdent des courants de fuite lorsqu'ils sont bloqués. Pour les interrupteurs 21 et 22, les courants de fuite s'ajoutent au courant de l'élément sensible 11. L'élément sensible 11 possède lui-même un courant de fuite généralement supérieur aux courants de fuite des interrupteurs. Ces courants de fuite peuvent être éliminés par des calibrations d'offset. Les courants de fuite des interrupteurs 21 et 22 sont ainsi traités simultanément.

Par contre, les courants de fuite de l'interrupteur I_3 s'accumulent au point C, donc sur une des armatures du condensateur 200. Ces courants de fuite modifient petit à petit la valeur de la charge accumulée dans le condensateur 200 lors de la phase d'initialisation. Lorsque la dérive de la valeur des contre-charges devient inacceptable, il faut relancer un cycle d'initialisation. Comme il est souhaitable d'espacer au maximum les cycles d'initialisation, on a tout intérêt à réduire autant que possible le courant de fuite de l'interrupteur I_3.

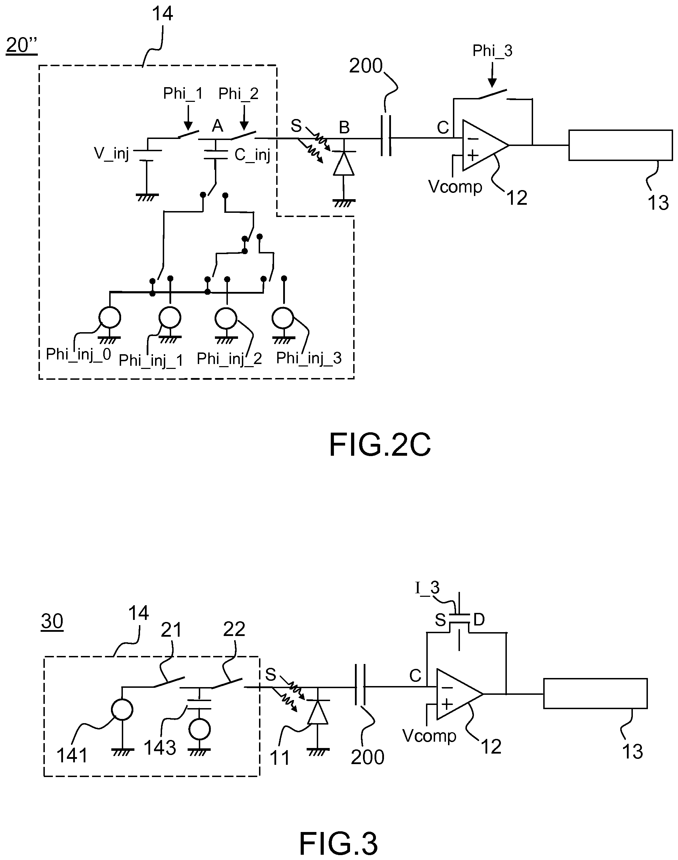

La figure 3 représente un schéma électrique d'un pixel 30, autre mode de réalisation de la première variante présentée sur la figure 2A dans un détecteur de rayonnement selon l'invention. Le schéma électrique du pixel 30 comprend les mêmes éléments que le schéma du pixel 20 représenté sur la figure 2A. L'interrupteur I_3 est un transistor de type MOS comprenant une grille G, une source S, un drain D. La source S et le drain D forment deux bornes. Une première borne (dans cet exemple la source) est connectée à la deuxième entrée du comparateur 12, et une seconde borne (dans cet exemple le drain) est connectée à la sortie du comparateur 12. Il est à noter que les appellations source et drain peuvent être inversées sur un transistor MOS en contre-réaction d'un amplificateur.

La fuite sur la source S peut provenir d'une fuite dépendant de la tension source-drain. Cette tension est nulle à la fin de la phase d'initialisation, mais ensuite, si le potentiel de source, c'est-à-dire le potentiel d'entrée du comparateur 12, bouge très peu, le potentiel drain, c'est-à-dire le potentiel de sortie du comparateur 12, bouge au contraire beaucoup en fonction des photocharges détectées. La fuite peut aussi provenir d'une fuite dépendant de la tension source-substrat.

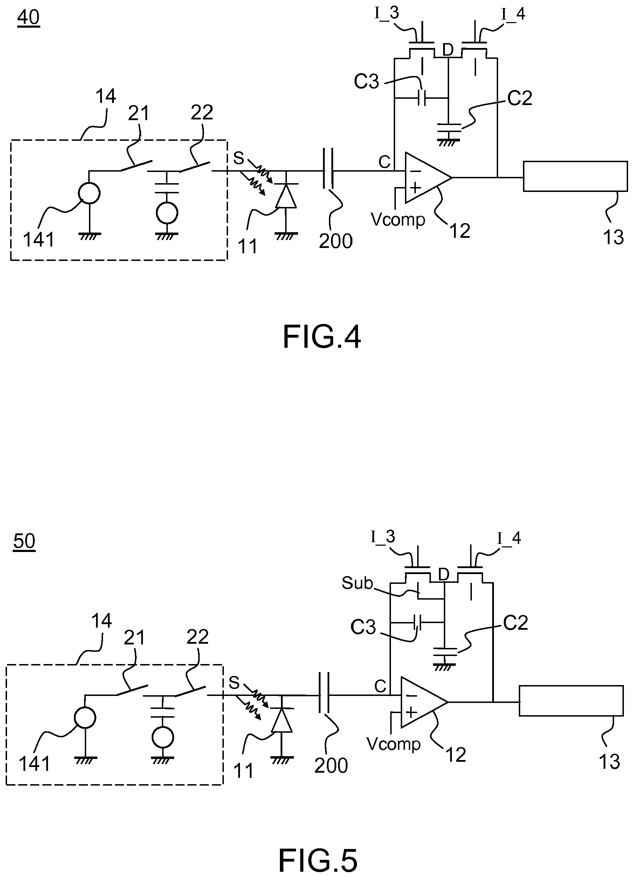

La figure 4 représente une autre variante d'un schéma électrique d'un pixel 40 dans un détecteur de rayonnement selon l'invention. Le schéma électrique du pixel 40 comprend les mêmes éléments que le schéma du pixel 30 représenté sur la figure 3. Il comprend en plus un interrupteur I_4 raccordé entre le drain D de l'interrupteur I_3 et la sortie du comparateur 12, un condensateur C2 raccordé entre le drain D de l'interrupteur I_3 et une tension fixe, un condensateur C3 raccordé entre la source S et le drain D de l'interrupteur I_3.

Cette variante permet de réduire le courant de fuite de l'interrupteur I_3. Pendant la phase d'initialisation, les interrupteurs I_3 et I_4 sont passants. Le fonctionnement reste inchangé par rapport au fonctionnement correspondant à la figure 2A. A la fin de la phase d'initialisation, les interrupteurs I_3 et I_4 sont bloqués. De préférence, l'interrupteur I_3 est bloqué avant l'interrupteur I_4. Avant le blocage de l'interrupteur I_3, les tensions source et drain du transistor de type MOS formant l'interrupteur I_3 sont égales. Le blocage de l'interrupteur I_3 transforme le montage du comparateur 12 en un montage intégrateur, le condensateur d'intégration étant C3. La charge parasite Qpar de l'interrupteur I_3 injectée en C par le blocage de l'interrupteur I_3 est donc principalement stockée sur le condensateur d'intégration C3. La charge parasite Qpar de l'interrupteur I_3 ne crée donc quasiment pas de perturbation au nœud C. Quant à la perturbation créée au nœud D, elle vaut -Qpar/C3. La charge parasite Qpar de l'interrupteur I_3 étant une charge parasite, donc faible, la perturbation du nœud D est donc aussi faible, bien que notablement plus importante qu'au nœud C. Le courant de fuite source-drain de l'interrupteur I_3 dépendant de la différence des tensions entre C et D est donc ainsi faible.

Lors du blocage de I_4, la charge parasite injectée au nœud D est stockée sur C2. Si la capacité de C2 a été choisie suffisamment grande, alors la variation de tension du nœud D est faible, et la différence des tensions entre C et D reste faible. Le courant de fuite source-drain de l'interrupteur I_3 reste donc faible.

La figure 5 représente une autre variante d'un schéma électrique d'un pixel 50 dans un détecteur de rayonnement selon l'invention. Le schéma électrique du pixel 50 comprend les mêmes éléments que le schéma du pixel 40 représenté sur la figure 4. Le transistor MOS formant l'interrupteur I_3 est réalisé sur un substrat Sub, et le substrat Sub est connecté au drain D de l'interrupteur I_3. La fin de la phase d'initialisation assure une quasi-égalité entre les tensions à la deuxième entrée du comparateur 12, au point D et $V_{comp\_bascul}$. La tension entre la source S et le drain D de l'interrupteur I_3 est réduite, d'où une réduction des courants de fuite dans l'interrupteur I_3. La connexion du substrat Sub de l'interrupteur I_3 au drain D assure que la tension source-substrat de l'interrupteur I_3 est quasiment nulle. De ce fait, le courant de fuite source-substrat est limité.

Il est à noter que la mise en œuvre de la connexion du substrat Sub de l'interrupteur I_3 au condensateur C2 suppose que le procédé technologique employé pour la réalisation des transistors MOS (et donc de l'interrupteur I_3) autorise à connecter comme on le souhaite le substrat Sub de l'interrupteur MOS I_3. Si on utilise un MOS P, cela ne pose généralement pas de problème. Néanmoins, si on utilise un MOS N, les règles de conception, dépendantes du procédé technologique utilisé, interdisent parfois cette connexion. Le choix d'un MOS N ou P dépend aussi de la tension de basculement du comparateur 12 que l'on souhaite avoir.

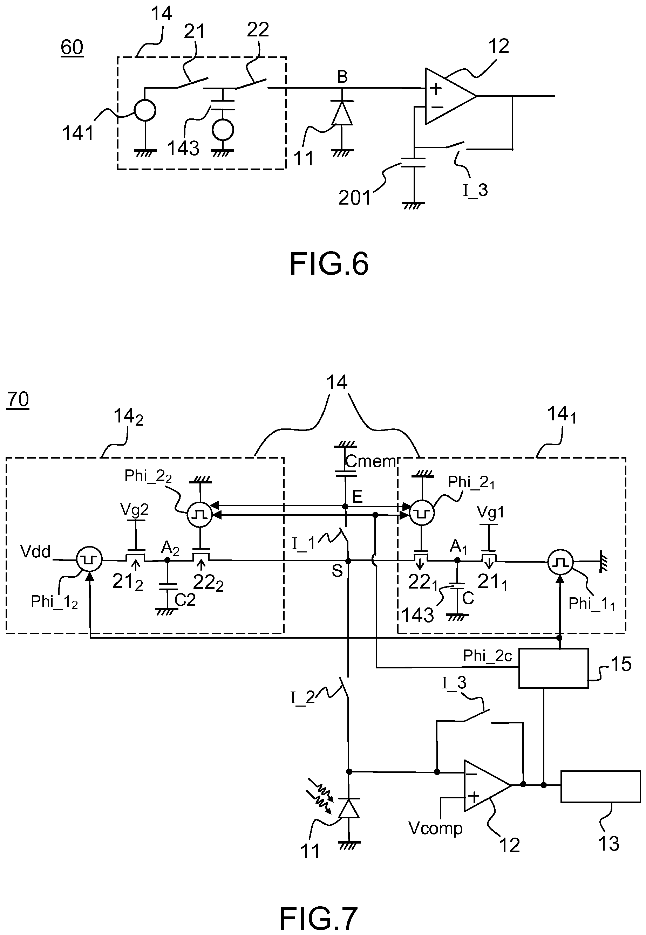

La figure 6 représente un autre mode de réalisation d'un schéma électrique d'un pixel 60 dans un détecteur de rayonnement selon l'invention. Selon l'invention, le circuit d'injection 14 est relié au nœud d'intégration B auquel est relié l'élément sensible 11. Le circuit d'injection 14 est apte à délivrer une première charge Q1 ou une deuxième charge Q2. Le comparateur 12 est relié au nœud d'intégration B au niveau de sa borne positive. Le circuit électronique du pixel 60 comprend en outre des moyens pour placer l'entrée inverseuse du comparateur 12 à un potentiel de seuil $V_{comp}$ quand le nœud d'intégration atteint un potentiel d'équilibre, et un moyen de mémorisation connecté à une entrée du comparateur 12 aptes à stocker la tension de basculement du comparateur 12.

Tout comme sur la figure 2A, le moyen de mémorisation comprend un condensateur 201 relié à une entrée du comparateur 12 et un interrupteur I_3 raccordé entre l'entrée du comparateur 12 à laquelle est relié le condensateur 201 et la sortie du comparateur 12. Le condensateur 201 est raccordé entre la borne négative du comparateur 12 et une tension fixe, par exemple la masse électrique.

Pendant une phase d'initialisation, l'interrupteur I_3 est passant. Les interrupteurs 21 et 22 du circuit d'injection 14 sont activés de façon à injecter successivement des premières charges Q1 au nœud d'intégration B, jusqu'à ce que le potentiel au nœud d'intégration atteigne un potentiel d'équilibre $V_{equ}$. Le potentiel du nœud d'intégration B n'évolue plus, c'est-à-dire que si on active les interrupteurs 21 et 22, la charge injectée est négligeable à un seuil prédéterminé près.

Le potentiel d'équilibre $V_{equ}$ du nœud d'intégration B, qui correspond au potentiel de la borne positive du comparateur 12, se retrouve à la borne négative de ce comparateur à un offset près.

On bloque alors l'interrupteur I_3. Le condensateur 201 permet alors de mémoriser une différence entre un potentiel de sortie Vs du circuit d'injection 14, dit potentiel d'équilibre $V_{equ}$, lorsque ladite première charge, est inférieure à un seuil prédéterminé, et un potentiel de référence $V_{ref}$. Dans cet exemple, le potentiel de référence, fixe, est la masse.

De même que dans l'exemple précédent, le potentiel de basculement correspond au potentiel d'équilibre $V_{equ}$.

Avec la variante présentée sur les figures 2A à 6, le potentiel de basculement $V_{comp\_bascul}$ du comparateur 12 est fixe et le potentiel d'équilibre $V_{equ}$ au nœud d'intégration B est différent de la tension de basculement $V_{comp\_bascul}$ du comparateur 12.

Avec la variante présentée sur la figure 6, la tension de seuil $V_{comp}$ du comparateur 12 est variable et est ajustée en fonction du potentiel d'équilibre $V_{equ}$ au nœud d'intégration.

Dans les deux cas, un condensateur permet de mémoriser la différence entre le potentiel d'équilibre $V_{equ}$ au nœud d'intégration B et un potentiel de référence, ce dernier étant :

- le potentiel $V_{comp\_bascul}$ dans la variante présentée sur les figures 2A à 5,
- la masse dans la variante présentée sur la figure 6.

Dans les variantes présentées aux figures 2A, 2B, 3, 4, 5 et 6, la quantité de charges injectées pendant la phase d'initialisation pour que le potentiel de sortie de l'injecteur atteigne un point d'équilibre dépend de la différence de potentiels entre la sortie du circuit d'injection 14 et une borne d'entrée (141 ou Phi_inj_1) du circuit d'injection 14.

Dans les figures 2A à 6, durant la phase d'utilisation, la quantité de charge injectée à chaque injection de charges dépend également de la différence de potentiels entre la sortie du circuit d'injection 14 et une borne d'entrée (141 ou Phi_inj_1) du circuit d'injection 14. Cependant, cela n'est pas le cas dans la figure 7. En effet, dans la variante décrite dans cette figure, le circuit d'injection de charge comporte deux entrées, et la charge injectée dépend de la différence de potentiels de chacune de ses entrées. Lors de la phase d'initialisation, une borne d'entrée est reliée à la borne de sortie, tandis que lors de la phase d'utilisation, la borne de sortie est reliée au nœud d'intégration, mais pas à une borne d'entrée.

Durant la phase d'utilisation, le fait que l'injection de charges soit indépendante du potentiel de sortie permet de s'affranchir de la fluctuation du potentiel de sortie lorsque la sortie du circuit d'injection est raccordée au nœud d'intégration.

La figure 7 représente une variante d'un schéma électrique d'un pixel 70 dans un détecteur de rayonnement selon l'invention. Le schéma électrique du pixel 70 comprend les mêmes éléments que le schéma du pixel 10 représenté sur la figure 1. Selon l'invention et de même que dans la variante présentée sur la figure 2A, le circuit d'injection 14 relié au nœud d'intégration B est apte à délivrer une charge Qtot. Ce circuit d'injection comporte un premier circuit d'injection $14_1$ et un deuxième circuit d'injection $14_2$.

Le premier circuit d'injection $14_1$, décrit dans la demande de brevet FR2977413, permet de délivrer une charge positive au point de sortie S. Il comporte deux transistors MOS $21_1$ et $22_1$, de type p, reliés à un générateur d'impulsions positives $Phi1_1$. L'impulsion $Phi1_1$ permet de précharger le nœud d'injection $A_1$ du premier circuit d'injection $14_1$. Le transistor $22_1$ est apte à être activé par une impulsion $Phi2_1$, pour injecter la charge au point de sortie S. Le potentiel crête du générateur d'impulsion $Phi\_2_1$ correspond au potentiel de l'entrée E.

Le circuit d'injection $14_2$ est un circuit similaire, pour délivrer une charge négative au point de sortie S. On note que dans le deuxième circuit d'injection, les transistors MOS $21_2$ et $22_2$ sont des transistors de type n. L'impulsion $Phi1_2$ permet de précharger le nœud d'injection $A_2$ du deuxième circuit d'injection $14_2$. Le transistor $22_2$ est apte à être activé par une impulsion $Phi2_2$, pour injecter la charge au point de sortie S. Le potentiel crête du générateur d'impulsion $Phi\_2_2$ correspond au potentiel de l'entrée E.

Le moyen de mémorisation comprend un condensateur Cmem, dont une première borne est connectée au nœud E et dont une seconde borne est connectée à un potentiel de référence. Le moyen de mémorisation comprend également un interrupteur I_1 raccordé entre le nœud E et le point de sortie S. Le nœud E est équivalent au nœud d'intégration B quand l'interrupteur I_1 est passant.

Notons que les transistors $22_1$ et $22_2$ sont polarisés en mode de saturation : la charge qu'ils delivrent ne dépend pas du potentiel au point de sortie S. Par ailleurs, les deux circuits d'injection $14_1$ et $14_2$ comportent une même borne d'entrée E. Il existe un certain potentiel de E, pour lequel les charges respectivement injectées par le premier et le deuxième circuit d'injection ($14_1$ et $14_2$) s'annulent.

Les circuits d'injection $14_1$ et $14_2$ sont activés de façon synchrone. A cet effet, le circuit électronique représenté sur la figure 7 comprend également un circuit de commande 15 de façon à déclencher une série d'injections de charges indépendamment de la sortie du comparateur 12 pendant la phase d'initialisation.

Lors de la phase d'initialisation, l'interrupteur I_1 est passant. Ainsi, le potentiel de sortie $V_S$ de l'injecteur est égal au potentiel d'entrée $V_E$ ($V_S = V_E$). Un interrupteur I_2, situé entre la sortie de l'injecteur et le nœud d'intégration B, est préférentiellement bloqué.

La phase d'initialisation consiste à actionner les circuits d'injection $14_1$ et $14_2$ une série de fois. A chaque injection, le nœud d'injection S reçoit la charge $Qtot_1 = C \times (Vg1 - V_S) + C2 \times (Vg2 - V_S) + Qpar$. La charge injectée $Qtot_1$ dépend de la valeur de $V_S$ :

Si Vs > (C x Vg1 + C2 x Vg2 + Qpar)/(C+C2), alors $Qtot_1 < 0$, et $V_S$ diminue ;
Si Vs < (C x Vg1 + C2 x Vg2 + Qpar)/(C+C2), alors $Qtot_1 > 0$, et $V_S$ augmente ;
Si Vs = (C x Vg1 + C2 x Vg2 + Qpar)/(C+C2), alors $Qtot_1 = 0$, et $V_S$ est constante.

En fin de phase d'initialisation une valeur d'équilibre $V_{equ}$ est obtenue pour

$$V_{equ} = (C \times Vg1 + C2 \times Vg2 + Qpar)/(C+C2).$$

Cette valeur prend en compte les parasites ou la dérive thermique qu'il peut y avoir.

Le potentiel de sortie $V_S$ atteint alors un potentiel d'équilibre $V_{equ}$, pouvant être mémorisé aux bornes du condensateur Cmem en bloquant l'interrupteur I_1. Ainsi, le condensateur forme un moyen de mémorisation apte à stocker une différence de potentiel entre le potentiel d'équilibre et un potentiel de référence, en l'occurrence la masse.

A la fin de la phase d'initialisation, les interrupteurs I_2 et I_3 sont rendus passants. Ainsi, $V_B = V_S = V_{comp\_bascul}$. L'interrupteur I_3 est alors bloqué.

Lors de la phase de fonctionnement, une des commandes (Vg1, Vg2) d'un transistor $21_1$ ou $21_2$ est ajustée, de façon que l'injecteur 14 injecte une charge non nulle $Qtot_2$ et indépendante du potentiel de sortie $V_S$.

Ainsi, lors de la phase de fonctionnement, la charge injectée ne dépend que du potentiel d'équilibre $V_{equ}$ et du potentiel de commande (Vg1, Vg2) ainsi modifié. Chaque commande Vg1, respectivement Vg2, constitue une borne d'entrée du circuit d'injection $14_1$, respectivement $14_2$.

Comme décrit précédemment, lors de la phase d'initialisation, on laisse la tension au nœud de sortie S évoluer pour trouver sa valeur d'équilibre. Afin que cet état d'équilibre soit obtenu, il est nécessaire que l'élément sensible 11 ne délivre pas de courant sur ce nœud S. Dans le cas de la variante décrite en figure 7, ceci est préférentiellement obtenu en bloquant l'interrupteur I_2 pendant cette phase d'initialisation. Pour les cas des variantes décrites dans les figures 2A à 6, une solution de base consiste à effectuer la phase d'initialisation à un moment où l'élément sensible 11 n'est pas soumis au rayonnement auquel il est sensible. Ceci est en particulier possible en radiologie lorsque des tubes émetteurs de rayons X pulsés sont utilisés. Entre deux phases d'irradiation correspondant à deux images successives, il y a une phase d'obscurité dont on peut profiter pour faire l'initialisation.

Néanmoins, pour certaines applications, l'irradiation est continue. C'est le cas en radiologie lorsque des tubes émetteurs de rayons X continus sont utilisés. C'est aussi le cas pour un détecteur de rayonnement visible ou infrarouge. De plus, même avec une phase d'obscurité, il arrive que le courant de l'élément sensible 11 ne s'annule pas. C'est le cas par exemple lorsqu'il y a du traînage qui peut être dû au détecteur lui-même ou à un autre élément tel qu'une couche scintillatrice recouvrant un élément photosensible.

Il faut donc stopper le courant de l'élément sensible 11 pendant la phase d'initialisation.

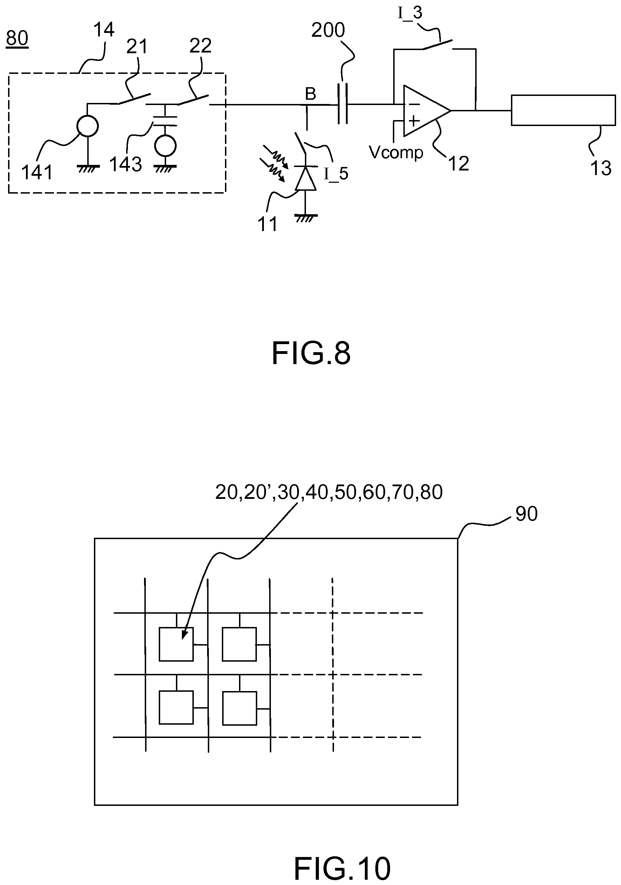

La figure 8 représente une autre variante d'un schéma électrique d'un pixel dans un détecteur de rayonnement selon l'invention. Le schéma électrique du pixel 80 comprend les mêmes éléments que le schéma du pixel 20 représenté sur la figure 2A. Dans la figure 8, le circuit électronique comprend un interrupteur I_5 raccordé entre l'élément sensible 11 et le nœud d'intégration B. De même, il est tout à fait possible de raccorder l'interrupteur I_5 entre l'élément sensible 11 et le nœud d'intégration B dans les schémas électriques des pixels 20', 30, 40, 50, 60 et 70 représentés sur les figures 2B, 3, 4, 5, 6 et 7.

La phase d'initialisation comporte au préalable une étape de déconnexion de l'élément sensible 11 du nœud d'intégration B au moyen de l'interrupteur I_5. Pendant la phase d'initialisation, l'interrupteur I_5 est ouvert. Il est à noter que les charges créées par l'éclairement pendant l'ouverture de l'interrupteur I_5 ne sont pas perdues. Elles s'accumulent sur la capacité de l'élément sensible 11 et rejoindront le nœud d'intégration B après la fin de la phase d'initialisation, après fermeture de l'interrupteur I_5.

Avantageusement, on peut remplacer l'élément sensible 11 et l'interrupteur I_5 par une diode pincée, aussi appelée « pinned diode » dans la littérature anglo-saxonne. Et pour pouvoir travailler en irradiation continue, on peut utiliser une diode pincée munie d'un transistor de sortie, aussi appelé Transfer Gate dans la littérature anglo-saxonne. Une telle diode pincée dispose de plusieurs avantages. La zone de détection et la zone de drain sur laquelle les charges s'accumulent sont disjointes. La zone de drain est notablement moins capacitive que dans une photodiode classique pour laquelle la zone capacitive correspond à la zone de détection. Le circuit électronique dans lequel la diode pincée est intégrée est donc beaucoup plus sensible. Lorsque le transistor de sortie est bloqué, les charges s'accumulent sur la zone de détection, et la capacité électrique de la sortie reste égale à celle de la zone de drain. Elle est donc inchangée. Ceci améliore la qualité de la phase d'initialisation.

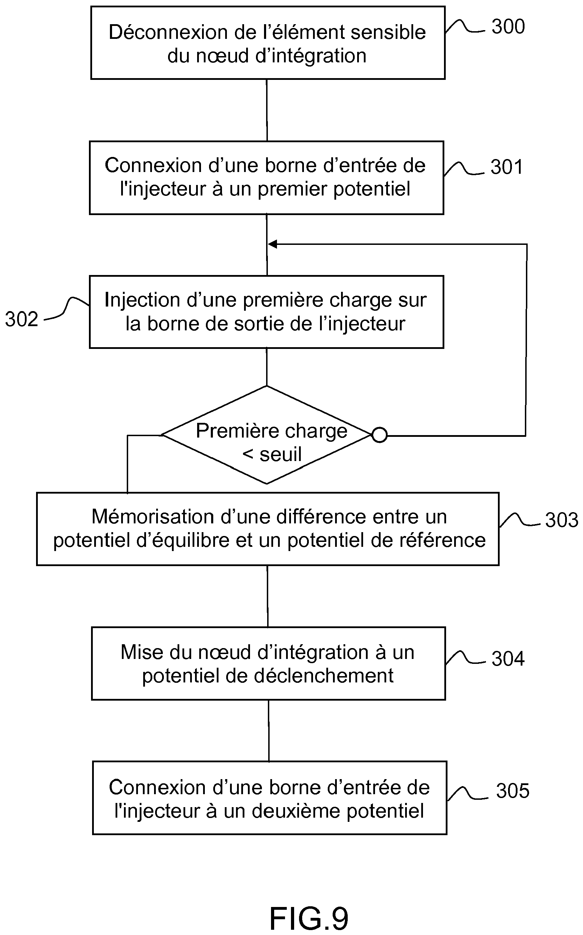

La figure 9 illustre les étapes d'une phase d'initialisation mettant en œuvre le circuit électronique selon l'invention. La phase d'initialisation comporte les étapes suivantes :

- Connexion d'une borne d'entrée de l'injecteur à un premier potentiel (étape 301),
- Injection d'une première charge sur la borne de sortie de l'injecteur (étape 302),
- Mémorisation d'une différence entre un potentiel de sortie Vs du circuit d'injection 14, dit potentiel d'équilibre $V_{equ}$, et un potentiel de référence $V_{ref}$, cette mémorisation étant effectuée de préférence lorsque ladite première charge, délivrée par le circuit d'injection, est inférieure à un seuil prédéterminé (étape 303),
- Mise du nœud d'intégration à un potentiel de déclenchement (étape 304),
- Connexion d'une borne d'entrée de l'injecteur à un deuxième potentiel (étape 305), de telle sorte que l'injecteur délivre une deuxième charge en fonction de la différence entre le potentiel du nœud d'intégration et le potentiel de déclenchement.

La phase d'initialisation peut comporter au préalable une étape de déconnexion de l'élément sensible 11 du nœud d'intégration B (étape 300).

Selon la variante du schéma électrique d'un pixel selon l'invention, le circuit d'injection 14 peut injecter une première charge (étape 302) en fonction de la valeur du potentiel du nœud d'intégration B, et les interrupteurs 21, 22 du circuit d'injection 14 sont activés une pluralité de fois (étape 301). La pluralité est prédéterminée de façon à ce que les charges injectées atteignent une valeur inférieure à une valeur de seuil prédéterminé.

Ainsi, la phase d'initialisation comporte l'injection d'un nombre prédéterminé de premières charges, suite à quoi le nœud d'intégration B atteint un potentiel d'équilibre. Autrement dit, la phase d'initialisation comporte la commande d'un nombre prédéterminé N d'impulsions de déclenchement, de telle sorte qu'au bout de N impulsions, ladite première charge injectée soit inférieure audit seuil prédéterminé. N peut être égal à 1, mais est en général compris entre 10 et 100.

La figure 10 représente un détecteur de rayonnement 90 comprenant un circuit électronique selon l'invention. Le détecteur de rayonnement 90 peut comporter le circuit électronique 20, 20', 30, 40, 50, 60, 70 ou 80 représentés sur les figures 2A, 2B, 3, 4, 5, 6, 7 et 8. Le détecteur peut être un détecteur matriciel. Les pixels sont arrangés en lignes et en colonnes pour former une matrice. La matrice peut comporter une seule ligne. On parle dans ce cas de barrette.

Le compteur 13 peut être connecté en sortie du comparateur 12, de manière à comptabiliser des franchissements de la tension de seuil $V_{comp}$ par la tension de détection. Le compteur 13 peut aussi être connecté en bout de ligne de la matrice ou barrette.

Selon une variante, applicable à l'ensemble des modes de réalisations précédemment décrits, lors de la phase de fonctionnement du détecteur, la quantité de charges délivrée par le circuit d'injection de charges 14 est variable.

Autrement dit, le circuit d'injection de charges 14 est adapté pour générer une deuxième charge, mais également une troisième charge, différente de la deuxième charge.

Ainsi, durant la phase de fonctionnement, un moyen de commande peut agir sur le circuit d'injection de charges, de façon à moduler la charge délivrée par le circuit d'injection 14 à chaque injection de charge.

On rappelle qu'au début de la phase de fonctionnement, le nœud d'intégration B est placé à un potentiel de déclenchement, de façon que, lorsque le nœud d'intégration B intègre des charges générées par le détecteur, une injection de charges soit déclenchée jusqu'à ce que le potentiel au nœud d'intégration B atteigne le potentiel de déclenchement.

Lorsque le détecteur est utilisé en mode comptage, au cours d'une interaction, au cours de laquelle le détecteur de rayonnement collecte des électrons, le potentiel au nœud d'intégration B chute. Tant que le potentiel du nœud d'intégration B est inférieur au potentiel de déclenchement préalablement établi, le circuit commande des injections de contre-charges. Le nombre de cycles d'injections est un indicateur de l'énergie libérée dans le détecteur par l'interaction. Un compteur 13 permet le comptage du nombre de cycles d'injections de charge, ce qui permet une estimation de l'énergie.

Dans un tel fonctionnement, la charge injectée à chaque cycle doit être inférieure à l'énergie maximale. Il peut notamment s'agir de la moitié de l'énergie maximale, voire du dixième, voire du centième, en fonction de la performance souhaitée en terme de résolution en énergie. Typiquement, une contre-charge équivalente à 100 electrons peut être injectée à chaque cycle d'injection.

Lorsque le détecteur est utilisé en mode intégration, on accumule la quantité de charges collectées par le détecteur durant une période donnée. Le nombre de cycles d'injections est un indicateur de l'énergie libérée dans le détecteur pendant la durée d'intégration. Un compteur permet le comptage du nombre de cycles d'injections de charge, ce qui permet une estimation de l'énergie collectée au cours de la période d'interaction.

La dynamique de mesure est bien supérieure au cas précédent, la quantité de charges collectées pouvant être beaucoup plus importante. Dans un tel mode de réalisation, la contre-charge injectée à chaque cycle d'intégration peut être plus importante, par exemple 10 fois ou 100 fois supérieure à celle injectée lorsque le détecteur fonctionne en mode comptage. Le fait d'utiliser une contre-charge plus importante réduit le nombre de cycles d'injections de contre-charges, ce qui réduit la consommation, au détriment de la précision de l'estimation de la charge totale collectée par le détecteur.

Ainsi, lorsqu'on souhaite estimer la quantité de charges collectée lors de chaque interaction, (mode comptage), le circuit d'injection de charges est configuré pour injecter une deuxième quantité de charges Q2. Pour cela, un commutateur place une borne d'entrée du circuit d'injection à un deuxième potentiel (V_inj_2, Phi_inj_2).

A l'inverse, lorsqu'on souhaite estimer la quantité de charges collectée par le détecteur durant une période donnée, le circuit d'injection de charges 14 est configuré pour injecter une troisième quantité de charges Q3, telle que Q3 > Q2, comme représenté sur la figure 2C du pixel 20". Le schéma de la figure 2C comprend les mêmes éléments que le schéma de la figure 2B. De plus, un commutateur place une borne d'entrée du circuit d'injection 14 à un troisième potentiel (V_inj_3, Phi_inj_3).

Selon un perfectionnement, ce commutateur peut agir sur le circuit d'injection de contre charges 14 en fonction d'un nombre de cycles d'injections de contre charges mémorisé dans le compteur 13. La quantité de charge générée par chaque contre-charge est alors modulée en fonction du nombre de cycles d'injection enregistré dans le compteur 13.

Par exemple, lorsque le détecteur fonctionne en intégration, le circuit peut être configuré pour injecter une quatrième quantité de charges Q4. Pour cela, un commutateur place une borne d'entrée du circuit d'injection à un quatrième potentiel (V_inj4, Phi_inj4). Tant que le nombre d'injections de contre-charges n'a pas atteint un seuil prédéterminé, la quantité de charges à chaque injection s'élève à Q3. Lorsque le seuil est franchi, la quantité de charges à chaque injection s'élève à Q4, avec Q3 < Q4. Cela permet d'améliorer la précision de la mesure, en particulier pour les faibles irradiations.

Précisions qu'un tel perfectionnement, selon lequel, durant la phase de fonctionnement, le circuit d'injection 14 est apte à injecter une charge modulable, est compatible avec l'ensemble des modes de réalisation décrits.

Selon un autre perfectionnement de l'ensemble des modes de réalisation, ce commutateur peut agir sur le circuit d'injection de contre-charges 14 en fonction de la durée écoulée depuis un instant initial, qui peut correspondre au début de la phase d'intégration. La quantité de charges générée par chaque contre-charge est alors modulée en fonction de la durée s'étant écoulée depuis cet instant initial.

Tant que cette durée atteint un certain pourcentage, par exemple 90%, de la durée totale d'intégration T, la quantité de charges à chaque injection s'élève à Q3. Au-delà, et jusqu'à la fin de la période d'intégration T, la quantité de charges à chaque injection s'élève à Q4. Cela permet d'améliorer la précision de la mesure. Selon ce perfectionnement, Q4 < Q3. On peut par exemple avoir Q3 et Q4 correspondant respectivement à 10000 et 100 électrons.

Durant 90% de la durée de l'intégration, la quantité de signal est déterminée selon une précision grossière, la précision étant quantifiée par le terme anglo-saxon « Least Significant Bit » ou « bit de poids faible ». A la fin de l'intégration, la précision de la mesure est accrue.

Ainsi, au cours d'une même période d'intégration, le circuit d'injection de charges est apte à générer une quantité de charges variable (Q2, Q3, Q4).

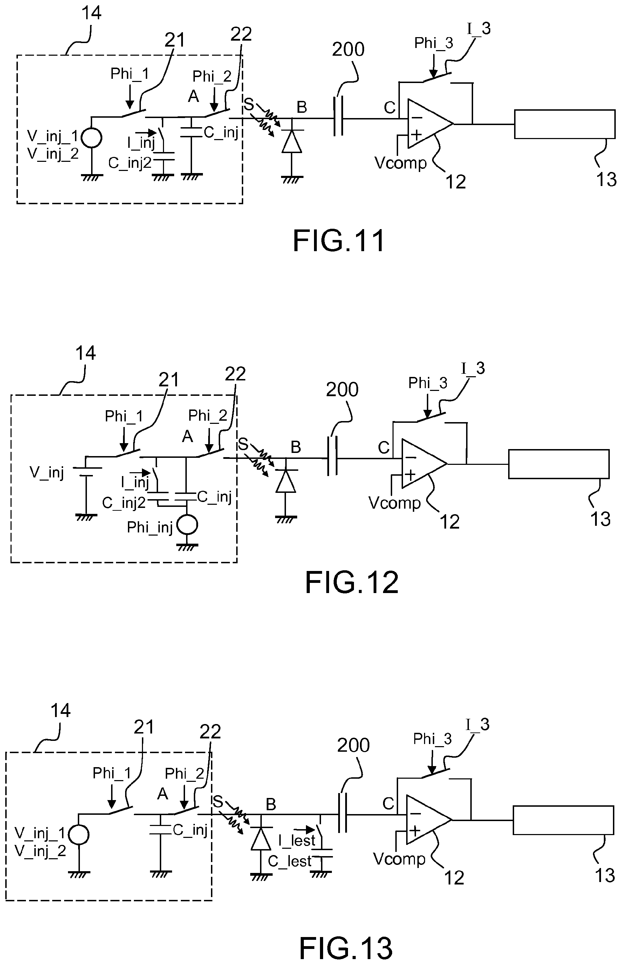

La figure 11 représente un circuit similaire au circuit représenté sur la figure 2A. Une deuxième capacité d'injection C_inj2 est connectée en amont du nœud d'intégration A, parallèlement à la capacité d'injection C_inj. Elle est reliée à un commutateur piloté par la commande I_inj.

Lorsque I_inj est bloqué, la valeur de la contre-charge injectée lors de chaque injection de charge est égale à :

$$Q2 = (V\_inj\_2 - V\_inj\_1) \times (C\_inj \times C\_det)/(C\_det + C\_inj).$$

Lorsque I_inj est passant la valeur de la contre-charge injectée lors de chaque injection de charge est égale à :

$$Q3 = (V\_inj\_2 - V\_inj\_1) \times ((C\_inj + C\_inj2) \times C\_det)/(C\_det + C\_inj + C\_inj2).$$

La figure 12 représente un circuit similaire au circuit représenté sur la figure 2B. Une deuxième capacité d'injection C_inj2 est connectée entre la borne d'entrée 145 et le nœud d'injection A, parallèlement à la capacité d'injection C_inj. Elle est reliée à un commutateur piloté par la commande I_inj.

Lorsque le commutateur piloté par la commande I_inj est bloqué, la valeur de la contre-charge injectée lors de chaque injection de charge est égale à :

$$Q2 = (Phi\_inj\_2 - Phi\_inj\_0) \times (C\_inj \times C\_det)/(C\_det + C\_inj).$$

Lorsque le commutateur piloté par la commande I_inj est passant la valeur de la contre-charge injectée lors de chaque injection de charge est égale à :

$$Q2 = (Phi\_inj\_2 - Phi\_inj\_0) \times ((C\_inj + C\_inj2) \times C\_det)/(C\_det + C\_inj + C\_inj2).$$

Ainsi, le circuit d'injection 14 peut comporter une deuxième capacité d'injection, apte à être connectée au nœud d'injection, ce qui permet de moduler la charge générée par le circuit d'injection 14.

On note qu'un tel circuit d'injection ne nécessite pas forcément le recours à une phase d'initialisation, afin d'établir un potentiel d'équilibre au niveau de la sortie de l'injecteur, correspondant à une injection de charge négligeable. De même, un tel circuit d'injection ne nécessite pas forcément un moyen de mémorisation du potentiel d'équilibre décrit en lien avec les figures 1 à 7.

Selon un autre mode de réalisation illustré sur la figure 13, on dispose d'un moyen pour moduler la capacité apparente du détecteur C_det. Il peut notamment s'agir d'une capacité dite capacité de lest et notée C_lest, disposée parallèlement au détecteur, et apte à être connectée au nœud d'intégration B lorsqu'un interrupteur I_lest est activé. L'activation de l'interrupteur I_lest augmente la capacité apparente C_app du détecteur, cette dernière prenant la valeur C_app = C_det + C_lest. Inversement, le blocage de l'interrupteur I_lest diminue la capacité apparente C_app du détecteur, cette dernière prenant la valeur C_app = C_det.

En se référant au mode de réalisation représenté sur la figure 2A, lors de chaque injection de charge, le potentiel au nœud d'intégration B varie selon l'expression :

$$\Delta V_B = (V\_inj\_2 - V\_inj\_1) \times C\_inj / (C\_det + C\_inj).$$

De même, en se référant au mode de réalisation représenté sur la figure 2B, lors de chaque injection de charge, le potentiel au nœud d'intégration B varie selon l'expression :

$$\Delta V_B = (Phi\_inj\_2 - Phi\_inj\_1) \times C\_inj / (C\_det + C\_inj).$$

On remarque que la variation de potentiel au nœud d'intégration B évolue en fonction de la capacité du détecteur. Lorsque le détecteur fonctionne en mode comptage, il est préférable que, pour une injection de charge donnée, la variation de potentiel au point B soit importante, de façon à diminuer le temps de réaction du comparateur. Aussi, il est préférable que C_det soit faible.

Lorsque le détecteur fonctionne en mode intégration, la quantité de charge injectée peut être choisie plus importante. Afin de limiter la variation de potentiel au point B, il est préférable que C_det soit plus élevée. En activant l'interrupteur I_lest, de façon à ajouter une capacité montée en parallèle par rapport au détecteur, on obtient, sur la configuration représentée sur la figure 2A

$$\Delta V_B = (V\_inj\_2 - V\_inj\_1) \times C\_inj / (C\_app + C\_inj).$$

L'ajout de la capacité C_lest permet de contrôler la plage de variation du potentiel au nœud d'intégration. Cela permet par exemple de placer le potentiel au nœud d'intégration dans une plage de fonctionnement acceptable, compatible avec le bon fonctionnement du circuit.

**Revendications**

1. Circuit électronique pour détecteur de rayonnement comprenant :

   • un élément sensible (11) au rayonnement,
   • un circuit d'injection (14), apte à injecter une charge à une borne de l'élément sensible (11), le circuit d'injection (14) s'étendant entre au moins une borne d'entrée (E1) et une borne de sortie (S), la borne de sortie (S) étant apte à être connectée audit élément sensible (11), le circuit d'injection (14) ayant un potentiel de sortie et étant apte à produire une charge sous l'effet d'une impulsion de déclenchement,
   • un comparateur (12) possédant un potentiel de basculement ($V_{comp\_bascul}$), avec une première entrée recevant un potentiel de seuil et une deuxième entrée apte à être connectée à un nœud d'intégration (B) pouvant stocker des charges électriques générées par l'élément sensible (11) à la réception du rayonnement, les charges entraînant une variation d'un potentiel au nœud d'intégration (B), le circuit d'injection (14) étant apte à injecter des charges au nœud d'intégration (B) à chaque basculement du comparateur (12) jusqu'à ce que le potentiel au nœud d'intégration (B) atteigne ou dépasse un potentiel d'équilibre (Vequ),
   • le circuit d'injection (14) est apte à injecter une première charge (Q1, $Qtot_1$) lorsqu'une borne d'entrée (E1) est raccordée à un premier potentiel d'entrée (V_inj_1, Phi_inj_1, Vg1, Vg2) et une deuxième charge (Q2, $Qtot_2$) lorsqu'une borne d'entrée (E1) est raccordée à un deuxième potentiel d'entrée (V_inj_2, Phi_inj_2, Vg1, Vg2),

   **caractérisé en ce que** :

   • le circuit électronique pour détecteur de rayonnement comporte un moyen de mémorisation d'une différence entre un potentiel d'équilibre et le potentiel de basculement (V_comp_bascul) qui correspond au potentiel de basculement du comparateur (12), le potentiel d'équilibre correspondant à un potentiel d'entrée (V_inj_1) du circuit d'injection (14) après une ou plusieurs injections de la première charge (Q1), le moyen de mémorisation étant relié à une entrée du comparateur et la borne de sortie (S) du circuit d'injection (14), l'entrée du comparateur étant apte à être connectée à une sortie du comparateur, de telle sorte que lors d'une injection d'une première charge, ladite entrée du comparateur est connectée à la sortie du comparateur ;
• **en ce que** le moyen de mémorisation comprend un troisième interrupteur (I_3) raccordé entre la deuxième entrée du comparateur (12) et la sortie du comparateur (12) ;
• et **en ce que** le circuit d'injection (14) est apte à injecter une deuxième charge (Q2, Qtot$_2$) dépendant du deuxième potentiel d'entrée (V_inj_2, Phi_inj_2, Vg1, Vg2) et dudit potentiel d'équilibre (V$_{equ}$) qui correspond au premier potentiel d'entrée.

2. Circuit électronique selon la revendication 1, **caractérisé en ce qu'**il comprend en outre un moyen pour mémoriser ladite différence de potentiel au bout d'un nombre prédéterminé d'impulsions de déclenchement.

3. Circuit électronique selon l'une des revendications précédentes, **caractérisé en ce qu'**il comprend un comparateur (12) possédant un potentiel de basculement (V$_{comp\_bascul}$), avec une première entrée recevant un potentiel de seuil et une deuxième entrée apte à être connectée à un nœud d'intégration (B) pouvant stocker des charges électriques générées par l'élément sensible (11) à la réception du rayonnement, les charges entraînant une variation d'un potentiel au nœud d'intégration (B), et **en ce qu'**il comprend un premier interrupteur (I_5) raccordé entre l'élément sensible (11) et le nœud d'intégration (B).

4. Circuit électronique selon l'une des revendications précédentes, **caractérisé en ce que** le moyen de mémorisation comprend :

   • un premier condensateur (Cmem), dont une première borne est connectée au nœud d'intégration (B) et dont une seconde borne est connectée à un potentiel de référence,
   • un deuxième interrupteur (I_1) raccordé entre le nœud d'intégration (B) et la première borne du premier condensateur (Cmem).

5. Circuit électronique selon la revendication 3, **caractérisé en ce que** le moyen de mémorisation comprend :

   • un deuxième condensateur (200) relié à la deuxième entrée du comparateur (12), relié à la deuxième entrée du comparateur (12).

6. Circuit électronique selon la revendication 5, **caractérisé en ce que** le troisième interrupteur (I_3) est un transistor de type MOS comprenant une grille (G), une source (S), un drain (D), la source (S) et le drain (D) formant deux bornes, **en ce que** une première borne est connectée à la deuxième entrée du comparateur (12) et une seconde borne est connectée à la sortie du comparateur (12), et **en ce que** le circuit électronique comprend :

   • un quatrième interrupteur (I_4) raccordé entre le drain (D) du troisième interrupteur (I_3) et la sortie du comparateur (12),
   • un troisième condensateur (C2) raccordé entre le drain (D) du troisième interrupteur (I_3) et une deuxième tension fixe,
   • un quatrième condensateur (C3) raccordé entre les deux bornes du troisième interrupteur (I_3).

7. Circuit électronique selon la revendication 6, **caractérisé en ce que** le transistor formant le troisième interrupteur (I_3) est réalisé sur un substrat (Sub), et **en ce que** le substrat (Sub) est connecté au drain (D).

8. Circuit électronique selon la revendication 3, **caractérisé en ce qu'**il comprend un comparateur (12) possédant un potentiel de basculement (V$_{comp\_bascul}$), avec une première entrée recevant un potentiel de seuil et une deuxième entrée apte à être connectée à un nœud d'intégration (B) pouvant stocker des charges électriques générées par l'élément sensible (11) à la réception du rayonnement, les charges entraînant une variation d'un potentiel au nœud d'intégration (B), et **en ce que** le moyen de mémorisation comprend :

   • un cinquième condensateur (201) relié à la première entrée du comparateur (12),
   • un troisième interrupteur (I_3) raccordé entre la première entrée du comparateur (12) à laquelle est relié le cinquième condensateur (201) et la sortie du comparateur (12).

9. Circuit électronique selon l'une des revendications 3 à 8 comportant un compteur (13) connecté en sortie du comparateur (12), de manière à comptabiliser le nombre de basculements du comparateur (12).

10. Détecteur matriciel composé de pixels **caractérisé en ce que** chaque pixel comprend un circuit électronique selon l'une des revendications précédentes.

**11.** Procédé mettant en œuvre le circuit électronique selon l'une des revendications 1 à 9, le procédé comportant une phase d'initialisation, comportant les étapes suivantes :

- Connexion d'une borne d'entrée du circuit d'injection à un premier potentiel
- Injection d'une première charge (Q1, $Qtot_1$) sur la borne de sortie du circuit d'injection

le procédé étant **caractérisé en ce que** la phase d'initialisation comporte en outre les étapes suivantes:

- Connexion de la borne d'entrée du comparateur, reliée au moyen de mémorisation, à la borne de sortie du comparateur par le troisième interrupteur (I_3),
- Mémorisation d'une différence entre un potentiel d'équilibre correspondant au premier potentiel d'entrée (V_inj_1) du circuit d'injection (Vs) et un potentiel de basculement (V_comp_bascul), le potentiel d'équilibre correspondant à un potentiel de sortie (Vs) du circuit d'injection après une ou plusieurs injections de la première charge (Q1), le potentiel de basculement qui correspond au potentiel de basculement du comparateur,
- Mise du nœud d'intégration à un potentiel de déclenchement, le potentiel de déclenchement correspondant au potentiel d'équilibre du nœud d'intégration (B) au delà duquel le circuit d'injection injecte une deuxième charge,
- Connexion d'une borne d'entrée du circuit d'injection à un deuxième potentiel, de telle sorte que le circuit d'injection délivre une deuxième charge (Q2, $Qtot_2$) en fonction de la différence entre le potentiel du nœud d'intégration (B) et le potentiel de déclenchement jusqu'à ce que le potentiel au noeud d'intégration (B) atteigne ou dépasse le potentiel de déclenchement,
et **en ce qu'**il comporte une phase de fonctionnement normal différente de la phase d'initialisation quand le troisième interrupteur (I_3) est ouvert pour déconnecter la sortie du comparateur (12) avec la première et deuxième entrées du comparateur (12) pour générer une deuxième charge.

**12.** Procédé selon la revendication 11, **caractérisé en ce que** la phase d'initialisation comporte l'injection d'un nombre prédéterminé de premières charges, suite à quoi le nœud d'intégration (B) atteint un potentiel d'équilibre.

**13.** Procédé selon la revendication 12, **caractérisé en ce que** le potentiel d'équilibre correspond au potentiel au nœud d'intégration (B) à l'issue d'une phase d'initialisation, ledit potentiel d'équilibre constituant alors le potentiel de déclenchement, au deçà ou au-delà duquel le circuit d'injection délivre une deuxième charge.

**14.** Procédé selon l'une des revendications 11 à 13, **caractérisé en ce que** ladite différence de potentiel entre ledit potentiel d'équilibre et le potentiel de basculement est mémorisée aux bornes d'un condensateur de liaison, ledit condensateur étant disposé entre le nœud d'intégration du détecteur et la deuxième entrée du comparateur (12).

**Patentansprüche**

**1.** Elektronische Schaltung für einen Strahlungsdetektor, die Folgendes umfasst:

- ein für Strahlung sensibles Element (11),
- eine Injektionsschaltung (14), die dazu geeignet ist, eine Ladung an einem Anschluss des sensiblen Elements (11) zu injizieren, wobei sich die Injektionsschaltung (14) zwischen mindestens einem Eingangsanschluss (E1) und einem Ausgangsanschluss (S) erstreckt, wobei der Ausgangsanschluss (S) dazu geeignet ist, um mit dem sensiblen Element (11) verbunden zu werden, wobei die Injektionsschaltung (14) ein Ausgangspotential hat und dazu geeignet ist, eine Ladung unter der Wirkung eines Auslöseimpulses zu produzieren,
- einen Komparator (12) mit einem Umschaltpotential ($V_{comp\_bascul}$), wobei ein erster Eingang ein Schwellenpotential empfängt und ein zweiter Eingang dazu geeignet ist, mit einem Integrationsknoten (B) verbunden zu werden, der elektrische Ladungen speichern kann, die vom sensiblen Element (11) bei Empfang von Strahlung erzeugt wurden, , wobei die Ladungen eine Variation eines Potentials am Integrationsknoten (B) bewirken, wobei die Injektionsschaltung (14) dazu geeignet ist, bei jedem Umschalten des Komparators (12) Ladungen in den Integrationsknoten (B) zu injizieren, bis das Potential am Integrationsknoten (B) ein Gleichgewichtspotential ($V_{equ}$) erreicht oder überschreitet,
- die Injektionsschaltung (14) dazu geeignet ist, eine erste Ladung (Q1, $Qtot_1$) zu injizieren, wenn ein Eingangsanschluss (E1) an ein erstes Eingangspotential (V_inj_1, Phi_inj_1, Vg1, Vg2) angeschlossen wird, und eine zweite Ladung (Q2, $Qtot_2$), wenn ein Eingangsanschluss (E1) an ein zweites Eingangspotential (V_inj_2, Phi_inj_2, Vg1, Vg2) angeschlossen wird,

**dadurch gekennzeichnet, dass**:

- die elektronische Schaltung für einen Strahlendetektor ein Mittel zum Speichern einer Differenz zwischen einem Gleichgewichtspotential und dem Umschaltpotential (V_comp_bascul) umfasst, das dem Umschaltpotential des Komparators (12) entspricht, wobei das Gleichgewichtspotential einem Eingangspotential (V_inj_1) der Injektionsschaltung (14) nach einer oder mehreren Injektionen der ersten Ladung (Q1) entspricht, wobei das Speichermittel mit einem Eingang des Komparators und dem Ausgangsanschluss (S) der Injektionsschaltung (14) verbunden ist, wobei der Eingang des Komparators dazu geeignet ist, mit einem Ausgang des Komparators verbunden zu werden, so dass bei einer Injektion einer ersten Ladung der Eingang des Komparators mit dem Ausgang des Komparators verbunden wird;
- dadurch, dass das Speichermittel einen dritten Schalter (I_3) umfasst, der zwischen dem zweiten Eingang des Komparators (12) und dem Ausgang des Komparators (12) geschaltet ist;
- und dadurch, dass die Injektionsschaltung (14) dazu geeignet ist, eine zweite Ladung (Q2, $Qtot_2$) in Abhängigkeit vom zweiten Eingangspotential (V_inj_2, Phi_inj_2, Vg1, Vg2) und vom Gleichgewichtspotential ($V_{equ}$) zu injizieren, das dem ersten Eingangspotential entspricht.

2. Elektronische Schaltung nach Anspruch 1, **dadurch gekennzeichnet, dass** sie ferner ein Mittel zum Speichern der Potentialdifferenz am Ende einer vorbestimmten Anzahl von Auslöseimpulsen umfasst.

3. Elektronische Schaltung nach einem der vorherigen Ansprüche, **dadurch gekennzeichnet, dass** sie einen Komparator (12) mit einem Umschaltpotential ($V_{comp\_bascul}$) umfasst, wobei ein erster Eingang ein Schwellenpotential empfängt und ein zweiter Eingang, der dazu geeignet ist, mit einem Integrationsknoten (B) verbunden zu werden, der elektrische Ladungen speichern kann, die vom sensiblen Element (11) beim Empfang von Strahlung erzeugt wurden, wobei die Ladungen eine Variation eines Potentials am Integrationsknoten (B) bewirken, und dadurch, dass sie einen ersten Schalter (I_5) umfasst, der zwischen dem sensiblen Element (11) und dem Integrationsknoten (B) geschaltet ist.

4. Elektronische Schaltung nach einem der vorherigen Ansprüche, **dadurch gekennzeichnet, dass** das Speichermittel Folgendes umfasst:

- einen ersten Kondensator (Cmem), von dem ein erster Anschluss mit dem Integrationsknoten (B) verbunden ist und von dem ein zweiter Anschluss mit einem Referenzpotential verbunden ist,
- einen zweiten Schalter (I_1), der zwischen dem Integrationsknoten (B) und dem ersten Anschluss des ersten Kondensators (Cmem) geschaltet ist.

5. Elektronische Schaltung nach Anspruch 3, **dadurch gekennzeichnet, dass** das Speichermittel Folgendes umfasst:

- einen mit dem zweiten Eingang des Komparators (12) verbundenen zweiten Kondensator (200), der mit dem zweiten Eingang des Komparators (12) verbunden ist.

6. Elektronische Schaltung nach Anspruch 5, **dadurch gekennzeichnet, dass** der dritte Schalter (I_3) ein Transistor des MOS-Typs ist, der ein Gate (G), eine Source (S), einen Drain (D) umfasst, wobei die Source (S) und der Drain (D) zwei Anschlüsse bilden, dadurch, dass ein erster Anschluss mit dem zweiten Eingang des Komparators (12) verbunden ist und ein zweiter Anschluss mit dem Ausgang des Komparators (12) verbunden ist, und dadurch, dass die elektronische Schaltung Folgendes umfasst:

- einen vierten Schalter (I_4), der zwischen dem Drain (D) des dritten Schalters (I_3) und dem Ausgang des Komparators (12) geschaltet ist,
- einen dritten Kondensator (C2), der zwischen dem Drain (D) des dritten Schalters (I_3) und einer zweiten festen Spannung geschaltet ist,
- einen vierten Kondensator (C3), der zwischen den beiden Anschlüssen des dritten Schalters (I_3) geschaltet ist.

7. Elektronische Schaltung nach Anspruch 6, **dadurch gekennzeichnet, dass** der den dritten Schalter (I_3) bildende Transistor auf einem Substrat (Sub) realisiert ist, und dadurch, dass das Substrat (Sub) mit dem Drain (D) verbunden ist.

8. Elektronische Schaltung nach Anspruch 3, **dadurch gekennzeichnet, dass** sie einen Komparator (12) mit einem Umschaltpotential ($V_{comp\_bascul}$) umfasst, wobei ein erster Eingang ein Schwellenpotential empfängt und ein zweiter Eingang dazu geeignet ist, mit einem Integrationsknoten (B) verbunden zu sein, der elektrische Ladungen speichern kann, die vom sensiblen Element (11) beim Empfang von Strahlung erzeugt wurden, wobei die Ladungen eine Variation eines Potentials am Integrationsknoten (B) bewirken, und dadurch, dass das Speichermittel Folgendes umfasst:

- einen fünften Kondensator (201), der mit dem ersten Eingang des Komparators (12) verbunden ist,
- einen dritten Schalter (I_3), der zwischen dem ersten Eingang des Komparators (12), mit dem der fünfte Kondensator (201) verbunden ist, und dem Ausgang des Komparators (12) geschaltet ist.

9. Elektronische Schaltung nach einem der Ansprüche 3 bis 8, die einen Zähler (13) umfasst, der am Ausgang des Komparators (12) verbunden ist, um die Anzahl der Umschaltungen des Komparators (12) zu zählen.

10. Matrixdetektor bestehend aus Pixeln, **dadurch gekennzeichnet, dass** jedes Pixel eine elektronische Schaltung nach einem der vorherigen Ansprüche umfasst.

11. Verfahren unter Verwendung der elektronischen Schaltung nach einem der Ansprüche 1 bis 9, wobei das Verfahren eine Initialisierungsphase umfasst, das die folgenden Schritte beinhaltet:

- Verbinden eines Eingangsanschlusses der Injektionsschaltung mit einem ersten Potential,
- Injizieren einer ersten Ladung (Q1, $Qtot_1$) in den Ausgangsanschluss der Injektionsschaltung, wobei das Verfahren **dadurch gekennzeichnet ist, dass** die Initialisierungsphase ferner die folgenden Schritte beinhaltet:
- Verbinden des Eingangsanschlusses des mit dem Speichermittel verbundenen Komparators mit dem Ausgangsanschluss des Komparators mittels des dritten Schalters (I_3),
- Speichern einer Differenz zwischen einem Gleichgewichtspotential entsprechend dem ersten Eingangspotential (V_inj_1) der Injektionsschaltung (Vs) und einem Umschaltpotential (V_comp_bascul), wobei das Gleichgewichtspotential einem Ausgangspotential (Vs) der Injektionsschaltung nach einer oder mehreren Injektionen der ersten Ladung (Q1) entspricht, wobei das Umschaltpotential dem Umschaltpotential des Komparators entspricht,
- Bringen des Integrationsknotens auf ein Auslösepotential, wobei das Auslösepotential dem Gleichgewichtspotential des Integrationsknotens (B) entspricht, jenseits dessen die Injektionsschaltung eine zweite Ladung injiziert,
- Verbinden eines Eingangsanschlusses der Injektionsschaltung mit einem zweiten Potential, so dass die Injektionsschaltung eine zweite Ladung (Q2, $Qtot_2$) in Abhängigkeit von der Differenz zwischen dem Potential des Integrationsknotens (B) und dem Auslösepotential liefert, bis das Potential des Integrationsknotens (B) das Auslösepotential erreicht oder überschreitet,
und dadurch, dass es eine normale Betriebsphase umfasst, die sich von der Initialisierungsphase unterscheidet, wenn der dritte Schalter (I_3) offen ist, um den Ausgang des Komparators (12) vom ersten und zweiten Eingang des Komparators (12) zu trennen, um eine zweite Ladung zu erzeugen.

12. Verfahren nach Anspruch 11, **dadurch gekennzeichnet, dass** die Initialisierungsphase das Injizieren einer vorbestimmten Anzahl von ersten Ladungen beinhaltet, wonach der Integrationsknoten (B) ein Gleichgewichtspotential erreicht.

13. Verfahren nach Anspruch 12, **dadurch gekennzeichnet, dass** das Gleichgewichtspotential dem Potential am Integrationsknoten (B) nach einer Initialisierungsphase entspricht, wobei das Gleichgewichtspotential dann das Auslösepotential bildet, auf oder über dem die Injektionsschaltung eine zweite Ladung liefert.

14. Verfahren nach einem der Ansprüche 11 bis 13, **dadurch gekennzeichnet, dass** die Potentialdifferenz zwischen dem Gleichgewichtspotential und dem Umschaltpotential an den Anschlüssen eines Verbindungskondensators gespeichert wird, wobei der Kondensator zwischen dem Integrationsknoten des Detektors und dem zweiten Eingang des Komparators (12) angeordnet ist.

**Claims**

1. An electronic circuit for radiation detector comprising:

• a radiation-sensitive element (11),

• an injection circuit (14), suitable for injecting a charge at a terminal of the sensitive element (11), the injection circuit (14) extending between at least one input terminal (E1) and one output terminal (S), the output terminal (S) being suitable for being connected to said sensitive element (11), the injection circuit (14) having an output potential and being suitable for producing a charge under the effect of a trigger pulse,

• a comparator (12) having a switchover potential ($V_{comp\_bascul}$) with a first input receiving a threshold potential and a second input suitable for being connected to an integration node (B) that can store electrical charges generated by the sensitive element (11) on reception of the radiation, the charges bringing about a variation of a potential at the integration node (B), the injection circuit (14) being suitable for injecting charges at the integration node (B) on each switchover of the comparator (12), until the potential at the integration node (B) reaches or exceeds an equilibrium potential ($V_{equ}$),

• the injection circuit (14) is suitable for injecting a first charge (Q1, $Qtot_1$) when an input terminal (E1) is connected to a first input potential (V_inj_1, Phi_inj_1, Vg1, Vg2) and a second charge (Q2, $Qtot_2$) when an input terminal (E1) is connected to a second input potential (V_inj_2, Phi_inj_2, Vg1, Vg2),

**characterized in that**:

• the electronic circuit for radiation detector comprises a means for storing a difference between an equilibrium potential and the switchover potential (V_comp_bascul) which corresponds to the switchover potential of the comparator (12), the equilibrium potential corresponding to an input potential (V_inj_1) of the injection circuit (14) after one or more injections of the first charge (Q1), the storage means being connected to an input of the comparator and the output terminal (S) of the injection circuit (14), the input of the comparator being able to be connected to an output of the comparator, so that during an injection of a first load, said input of the comparator is connected to the output of the comparator;

• **in that** the storage means comprises a third switch (I_3) connected between the second input of the comparator (12) and the output of the comparator (12);

• and **in that** the injection circuit (14) is suitable for injecting a second charge (Q2, $Qtot_2$) dependent on the second input potential (V_inj_2, Phi_inj_2, Vg1, Vg2) and on said equilibrium potential ($V_{equ}$) corresponding to the first entry potential.

2. The electronic circuit as claimed in claim 1, **characterized in that** it further comprises a means for storing said potential difference after a predetermined number of trigger pulses.

3. The electronic circuit as claimed in one of the preceding claims, **characterized in that** it comprises a comparator (12) having a switchover potential ($V_{comp\_bascul}$), with a first input receiving a threshold potential and a second input suitable for being connected to an integration node (B) that can store electrical charges generated by the sensitive element (11) on reception of the radiation, the charges bringing about a variation of a potential at the integration node (B), and **in that** it comprises a first switch (I_5) connected between the sensitive element (11) and the integration node (B).

4. The electronic circuit as claimed in one of the preceding claims, **characterized in that** the storage means comprises:

• a first capacitor (Cmem), a first terminal of which is connected to the integration node (B) and a second terminal of which is connected to a reference potential,

• a second switch (I_1) connected between the integration node (B) and the first terminal of the first capacitor (Cmem).

5. The electronic circuit as claimed in claim 3, **characterized in that** the storage means comprises:

• a second capacitor (200) linked to the second input of the comparator (12), linked to the second input of the comparator (12).

6. The electronic circuit as claimed in claim 5, **characterized in that** the third switch (I_3) is a transistor of MOS type comprising a gate (G), a source (S), a drain (D), the source (S) and the drain (D) forming two terminals, **in that** a first terminal is connected to the second input of the comparator (12) and a second terminal is connected to the output of the comparator (12), and **in that** the electronic circuit comprises:

• a fourth switch (I_4) connected between the drain (D) of the third switch (I_3) and the output of the comparator (12),
• a third capacitor (C2) connected between the drain (D) of the third switch (I_3) and a second fixed voltage,
• a fourth capacitor (C3) connected between the two terminals of the third switch (I_3).

7. The electronic circuit as claimed in claim 6, **characterized in that** the transistor forming the third switch (I_3) is produced on a substrate (Sub), and **in that** the substrate (Sub) is connected to the drain (D).

8. The electronic circuit as claimed in claim 3, **characterized in that** it comprises a comparator (12) having a switchover potential ($V_{comp\_bascul}$), with a first input receiving a threshold potential and a second input suitable for being connected to an integration node (B) that can store electrical charges generated by the sensitive element (11) on reception of the radiation, the charges bringing about a variation of a potential at the integration node (B), and **in that** the storage means comprises:

• a fifth capacitor (201) linked to the first input of the comparator (12),
• a third switch (I_3) connected between the first input of the comparator (12) to which the fifth capacitor (201) is linked and the output of the comparator (12).

9. The electronic circuit as claimed in one of claims 3 to 8, comprising a counter (13) connected at the output of the comparator (12), so as to count the number of switchovers of the comparator (12).

10. A matrix detector composed of pixels, **characterized in that** each pixel comprises an electronic circuit as claimed in one of the preceding claims.

11. A method implementing the electronic circuit as claimed in one of claims 1 to 9, the method comprising an initialization phase, comprising the following steps:

• connection of an input terminal of the injection circuit to a first potential,
• injection of a first charge (Q1, $Qtot_1$) on the output terminal of the injection circuit, the method being **characterized in that** the initialization phase further comprises the following steps:
• connection of the comparator input terminal, linked to the storage means, to the comparator output terminal by the third switch (I_3),
• storage of a difference between an equilibrium potential corresponding to the first input potential (V_inj_1) of the injection circuit (Vs) and a switchover potential (V_comp_bascul), the equilibrium potential corresponding to an output potential (Vs) of the injection circuit after one or more injections of the first charge (Q1), the switchover potential which corresponds to the switching potential of the comparator,
• setting the integration node to a trigger potential, the trigger potential corresponding to the equilibrium potential of the integration node (B) beyond which the injection circuit injects a second charge,
• Connection of an input terminal of the injection circuit to a second potential, such that the injection circuit delivers a second charge (Q2, Qtot2) as a function of the difference between the potential of the integration node (B) and the trigger potential until the potential at the integration node (B) reaches or exceeds the trigger potential,
and **in that** it has a normal operating phase different from the initialization phase when the third switch (I_3) is open to disconnect the output of the comparator (12) with the first and second inputs of the comparator (12) to generate a second charge.

12. The method as claimed in claim 11, **characterized in that** the initialization phase comprises the injection of a predetermined number of first charges, following which the integration node (B) reaches an equilibrium potential.

13. The method as claimed in claim 12, **characterized in that** the equilibrium potential corresponds to the potential at the integration node (B) after an initialization phase, said equilibrium potential then constituting the trigger potential, below or beyond which the injection circuit delivers a second charge.

14. The method as claimed in one of claims 11 to 13, **characterized in that** said potential difference between said equilibrium potential and the switchover potential is stored at the terminals of a link capacitor, said capacitor being arranged between the integration node of the detector and the second input of the comparator (12).

FIG.1

FIG.2A

FIG.2B

## FIG.2C

## FIG.3

**FIG.4**

**FIG.5**

FIG.6

FIG.7

EP 3 063 558 B1

# FIG.8

20,20',30,40,50,60,70,80

# FIG.10

26

Déconnexion de l'élément sensible du nœud d'intégration — 300

Connexion d'une borne d'entrée de l'injecteur à un premier potentiel — 301

302 — Injection d'une première charge sur la borne de sortie de l'injecteur

Première charge < seuil

Mémorisation d'une différence entre un potentiel d'équilibre et un potentiel de référence — 303

Mise du nœud d'intégration à un potentiel de déclenchement — 304

Connexion d'une borne d'entrée de l'injecteur à un deuxième potentiel — 305

FIG.9

FIG.11

FIG.12

FIG.13

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2977413

- US 2007285300 A